# EUROPEAN PATENT APPLICATION

(11) **EP 4 177 672 A1**
(43) Date of publication of application: **10.05.2023**
(21) Application number: 22203239.3
(22) Date of filing: 24.10.2022
(51) Int. Cl.: G03F 7/09

(54) **RESIST UNDERLAYER FILM MATERIAL, PATTERNING PROCESS, AND METHOD FOR FORMING RESIST UNDERLAYER FILM**

(30) Priority: 09.11.2021 JP 2021182853
(71) Applicant: SHIN-ETSU CHEMICAL CO., LTD., Tokyo 1000005 (JP)
(72) Inventor: SATOH, Hironori, Niigata (JP); KORI, Daisuke, Niigata (JP); KOBAYASHI, Naoki, Niigata (JP); YANO, Toshiharu, Niigata (JP)
(74) Representative: Sonnenhauser, Thomas Martin

(57) **Abstract**

The present invention provides a resist underlayer film material used in a multilayer resist method, the material containing: (A) a resin having a structural unit shown by the following general formula (1); and (B) an organic solvent. The resin content is 20 mass% or more. This provides: a resist underlayer film material having excellent filling property and adhesiveness, and favorable planarizing property; and a patterning process and a method for forming a resist underlayer film which use the material.

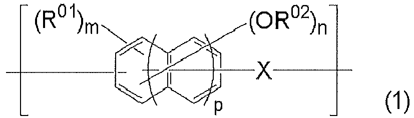

## Description

### TECHNICAL FIELD

The present invention relates to a resist underlayer film material, a patterning process, and a method for forming a resist underlayer film.

### BACKGROUND ART

As LSI advances toward high integration and high processing speed, miniaturization of pattern size is progressing rapidly. Along with this miniaturization, lithography technology has achieved fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble. Thereby, a pattern is formed by dissolving the exposed part, and the remaining resist pattern is used as an etching mask to process a substrate to be processed by dry etching.

However, when the pattern becomes finer, that is, the pattern width is reduced without changing the thickness of the photoresist film to be used, resolution performance of the photoresist film is lowered. In addition, pattern development of the photoresist film with a developer excessively increases what is called an aspect ratio, resulting in pattern collapse problem. Therefore, photoresist films have been thinned along with the pattern miniaturization.

On the other hand, a substrate to be processed has been generally processed by dry etching using a pattern-formed photoresist film as an etching mask. In practice, however, there is no dry etching method capable of providing an absolute etching selectivity between the photoresist film and the substrate to be processed. Hence, there are problems that the resist film is damaged and collapses during processing of the substrate, and that the resist pattern cannot be precisely transferred to the substrate to be processed. Accordingly, resist compositions have been required to have higher dry etching resistance along with the pattern miniaturization. Meanwhile, to enhance the resolution, resins used for photoresist compositions have been required to have low absorbance at the exposure wavelength. Accordingly, as the exposure light shifts to shorter wavelengths from i-beam to KrF and to ArF, the resin shifts to novolak resins, polyhydroxystyrene, and resins having aliphatic polycyclic skeletons. This shift actually accelerates an etching rate under dry etching conditions in processing the substrate, and recent photoresist compositions for high resolution tend to have low etching resistance.

As a result, a substrate to be processed has to be dry etched with a thinner photoresist film having lower etching resistance. A material and procedure reliably employed in this processing are urgently needed.

A multilayer resist method is one solution for these problems. This method is as follows: a middle layer film having a different etching selectivity from a photoresist film (i.e., a resist upper layer film) is placed between the resist upper layer film and a substrate to be processed; a pattern is formed in the resist upper layer film; then, the pattern is transferred to the middle layer film by dry etching using the resist upper layer film pattern as a dry etching mask; and the pattern is further transferred to the substrate to be processed by dry etching using the middle layer film as a dry etching mask.

One of the multilayer resist methods is a three-layer resist method, which can be performed with a typical resist composition used in the monolayer resist method. This three-layer resist method includes, for example, the following steps: an organic film made of a novolak resin or the like is formed as a resist underlayer film on a substrate to be processed; a silicon-containing film is formed as a silicon-containing resist middle layer film on the resist underlayer film; a usual organic photoresist film is formed as a resist upper layer film on the resist middle layer film. Since the organic resist upper layer film exhibits a favorable etching selectivity ratio relative to the silicon-containing resist middle layer film when dry etching is performed with fluorine-based gas plasma, the resist upper layer film pattern can be transferred to the silicon-containing resist middle layer film by employing dry etching with fluorine-based gas plasma. According to this method, even if a resist composition to be used has difficulty in forming a pattern with a sufficient film thickness for directly processing the substrate to be processed or has insufficient dry etching resistance for processing the substrate, the pattern can be transferred to the silicon-containing film (silicon-containing resist middle layer film). Moreover, the subsequent dry etching with oxygen-based or hydrogen-based gas plasma enables the pattern to be transferred into the organic film (resist underlayer film) made of a novolak resin or the like having a sufficient dry etching resistance for processing the substrate. Numerous resist underlayer films as described above have been already known and disclosed in, for example, Patent Document 1, etc.

On the other hand, in recent years, three-dimensional 3D-NAND memory is emerging as the mainstream memory. Manufacturing such 3D-NAND memory requires formation of a thick resist underlayer film by a single process in the multilayer resist method. Hence, the value of the resin concentration in the resist underlayer film material needs to be as high as 10 mass% or more. Moreover, recent 3D-NAND memories with many layers are actively developed. Accordingly, there are growing needs for a resist underlayer film having more excellent performance than conventional ones regarding gap-filling property to fill gaps in a pattern with the film without leaving voids.

As a resist underlayer film material capable of forming a thick resist underlayer film, for example, Patent Document 2 proposes a material containing a crosslinking agent in addition to an olefin-based polymer or novolak-based polymer. However, in this material, the amount of hydroxyl groups contained in the polymer structure is so large that the flowability is low in filling a substrate to be processed with a deep pattern as employed in the cutting edge process, and voids may remain.

Meanwhile, as a resist underlayer film material containing a compound with a structure protecting a hydroxyl group in a polymer, a material is known in which a hydroxyl group contained in a novolak-based polymer is protected with a group containing a triple bond (Patent Document 3). However, this material has insufficient adhesiveness to a substrate to be processed, and consequently may cause defect such as peeling during the process.

As described above, in manufacturing 3D-NAND memories in highly laminated forms, there have been demands for: a resist underlayer film material for manufacturing a semiconductor device, which has favorable filling property without causing defects, such as void and peeling; and a patterning process using such a resist underlayer film material.

### CITATION LIST

### PATENT LITERATURE

Patent Document 1: JP2004-205685 A
Patent Document 2: JP 6550760 B
Patent Document 3: JP 5821694 B

### SUMMARY OF INVENTION

### TECHNICAL PROBLEM

The present invention has been made in view of the above circumstances. An object of the present invention is to provide: a resist underlayer film material having excellent filling property and adhesiveness, and favorable planarizing property; and a patterning process and a method for forming a resist underlayer film which use the material.

### SOLUTION TO PROBLEM

To achieve the object, the present invention provides a resist underlayer film material used in a multilayer resist method, comprising:
(A) a resin having a structural unit shown by the following general formula (1); and
(B) an organic solvent,
   wherein the resin is contained in an amount of 20 mass% or more, 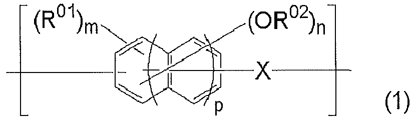
wherein R⁰¹ represents a saturated or unsaturated monovalent organic group having 1 to 30 carbon atoms optionally having a substituent; R⁰² represents a hydrogen atom or a saturated or unsaturated monovalent organic group having 1 to 30 carbon atoms optionally having a substituent, and the structures constituting R⁰² satisfy relations of a+b=1, 0.1≤a≤0.5, and 0.5≤b≤0.9, where "a" represents a proportion of the hydrogen atom, and "b" represents a proportion of the monovalent organic group; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1.

Incorporating such a structure enables the resist underlayer film material to have excellent filling property and adhesiveness, and favorable planarizing property. Adjusting the proportions in the structure within the aforementioned ranges makes it possible to achieve both void elimination and peeling inhibition when a substrate to be processed is filled with the material. Moreover, with the resin content of 20 mass% or more, a thick resist underlayer film can be formed by a single process.

Additionally, in the general formula (1), the R⁰² is preferably any of a hydrogen atom, an alkyl group having 1 to 10 carbon atoms, and structures shown in the following general formula (2), 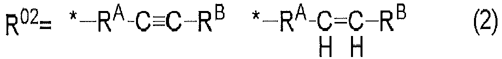 wherein * represents an attachment point to an oxygen atom, R^{A} represents a divalent organic group having 1 to 10 carbon atoms optionally having a substituent, and R^{B} represents a hydrogen atom or a monovalent organic group having 1 to 10 carbon atoms optionally having a substituent.

Incorporating such structures enables the resist underlayer film materials to have further excellent filling and planarizing properties.

Moreover, in the general formula (1), "a" and "b" preferably satisfy relations of a+b=1, 0.15≤a≤0.4, and 0.6≤b≤0.85.

By adjusting the proportions of the structures within such ranges, both of void elimination and peeling inhibition can be achieved in a particularly excellent manner when a substrate to be processed is filled.

Further, in the general formula (1), "p" is preferably 0.

Incorporating such a structure enables the resist underlayer film material to have particularly excellent filling property.

Further, in the general formula (1), "n" is preferably 1.

The resist underlayer film material containing such a structure can have quite excellent filling property.

Furthermore, the resin (A) preferably has a weight-average molecular weight of 3,000 to 10,000.

With such molecular weights, the resist underlayer film material containing this resin has favorable film formability, and can suppress generation of sublimation products during heat curing, and suppress contamination of the apparatus which would be caused by the sublimation products. Moreover, it is possible to suppress coating defect, and further excellent filling and planarizing properties are obtained.

In addition, the resist underlayer film material preferably comprises (C) a crosslinking agent.

Moreover, the resist underlayer film material preferably further comprises one or more of (D) an acid generator, (E) a surfactant, (F) a plasticizer, and (G) a pigment.

The inventive resist underlayer film material is practically preferable because fine adjustment of performances, such as coating-film formability by spin coating, curing temperature, filling and planarizing properties, and optical properties (light-absorption property), is possible in accordance with needs and demands by incorporating or not incorporating/selecting additives as described above.

Further, the present invention provides a patterning process for forming a pattern in a substrate to be processed, comprising steps of:
(I-1) applying the above-described resist underlayer film material onto the substrate to be processed, followed by heating to form a resist underlayer film;
(1-2) forming a resist upper layer film on the resist underlayer film by using a photoresist material;
(1-3) subjecting the resist upper layer film to pattern exposure and then development with a developer to form a pattern in the resist upper layer film;
(1-4) transferring the pattern to the resist underlayer film by dry etching while using the resist upper layer film having the formed pattern as a mask; and
(1-5) processing the substrate to be processed while using the resist underlayer film having the formed pattern as a mask to form the pattern in the substrate to be processed.

Furthermore, the present invention provides a patterning process for forming a pattern in a substrate to be processed, comprising steps of:
(II-1) applying the above-described resist underlayer film material onto the substrate to be processed, followed by heating to form a resist underlayer film;
(II-2) forming a silicon-containing resist middle layer film on the resist underlayer film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the resist underlayer film by dry etching while using the silicon-containing resist middle layer film having the transferred pattern as a mask; and
(II-7) processing the substrate to be processed while using the resist underlayer film having the formed pattern as a mask to form the pattern in the substrate to be processed.

Furthermore, the present invention provides a patterning process for forming a pattern in a substrate to be processed, comprising steps of:
(III-1) applying the above-described resist underlayer film material onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

In these ways, the inventive resist underlayer film material can be suitably employed in various patterning processes, 2-layer resist process, 3-layer resist process using a silicon-containing resist middle layer film, and 4-layer resist process additionally using an organic thin film. These patterning processes enable effective reductions in unevenness and steps of a substrate to be processed by forming a resist underlayer film, and are suitable for photolithography of resist upper layer films.

Moreover, in the inventive patterning processes, the substrate to be processed may have a structure or step with an aspect ratio of 10 or more.

Because of the use of the inventive resist underlayer film material capable of forming a resist underlayer film having high filling and planarizing properties, the inventive patterning processes are particularly useful for fine processing of a substrate having such a structure or step.

Further, the present invention provides a method for forming a resist underlayer film that serves as an organic filling film employed in a semiconductor device manufacturing process, the method comprising:
spin-coating a substrate to be processed with the above-described resist underlayer film material; and
heating the substrate to be processed coated with the resist underlayer film material at a temperature of 100°C or higher and 600°C or lower for 10 to 600 seconds to form a cured film.

Furthermore, the present invention provides a method for forming a resist underlayer film that serves as an organic filling film employed in a semiconductor device manufacturing process, the method comprising:
spin-coating a substrate to be processed with the above-described resist underlayer film material; and
heating the substrate to be processed coated with the resist underlayer film material under an atmosphere with an oxygen concentration of 1% or more and 21% or less to form a cured film.

Such methods make it possible to more considerably suppress mixing with a resist upper layer film by promoting the crosslinking reaction that takes place when the resist underlayer film is formed. Moreover, by appropriately adjusting the heating temperature, time, and oxygen concentration within the above-described ranges, it is possible to obtain a resist underlayer film having suitable filling, planarizing, and curing properties in accordance with use.

Furthermore, the present invention provides a method for forming a resist underlayer film that serves as an organic filling film employed in a semiconductor device manufacturing process, the method comprising:
spin-coating a substrate to be processed with the above-described resist underlayer film material; and
heating the substrate to be processed coated with the resist underlayer film material under an atmosphere with an oxygen concentration of less than 1% to form a cured film.

According to such a method, even when a substrate to be processed contains a material that is unstable under heating condition in an oxygen atmosphere, the substrate to be processed is not degraded, and the method is useful and makes it possible to more considerably suppress mixing with a resist upper layer film by promoting the crosslinking reaction when the resist underlayer film is formed.

In these events, the substrate to be processed may have a structure or step with an aspect ratio of 10 or more.

Because of the use of the inventive resist underlayer film material capable of forming a resist underlayer film having high filling and planarizing properties, the inventive methods for forming a resist underlayer film are particularly suitable for forming a resist underlayer film on a substrate having such a structure or step.

### ADVANTAGEOUS EFFECTS OF INVENTION

As described above, the resist underlayer film material, the patterning processes, and the methods for forming a resist underlayer film according to the present invention are particularly suitably utilized in multilayer resist processes including filling/planarizing a stepped uneven substrate to be processed, and are quite useful in fine patterning for manufacturing a semiconductor device. The present invention makes it possible to provide: a resist underlayer film material excellent in filling property, capable of forming a resist underlayer film without causing such defects as void and peeling, and having appropriate planarizing, etching, and optical properties even on a substrate to be processed which has a portion with a large aspect ratio that makes particularly gap-filling difficult, as typified by 3D-NAND memories being manufactured in highly laminated forms, especially in a fine patterning process by a multilayer resist method in a semiconductor-device manufacturing process; and patterning processes and methods for forming a resist underlayer film which use the material.

### BRIEF DESCRIPTION OF DRAWINGS

FIG. 1 is an explanatory diagram illustrating an example (3-layer resist process) of the inventive patterning processes.
FIG. 2 is an explanatory diagram illustrating a method for evaluating filling property.
FIG. 3 is an explanatory diagram illustrating a method for evaluating planarizing property.

### DESCRIPTION OF EMBODIMENTS

Hereinafter, the present invention will be described in more details. As noted above, there have been demands for: a resist underlayer film material having excellent filling property and appropriate planarizing property, and being capable of forming a resist underlayer film without such defects as void and peeling even on a substrate to be processed having a portion with a large aspect ratio that makes particularly gap-filling difficult, as typified by 3D-NAND memories being manufactured in highly laminated forms, in a fine patterning process by a multilayer resist method in a semiconductor-device manufacturing process; and a patterning process and a method for forming a resist underlayer film which use the material.

The present inventors have searched various resist underlayer film materials and patterning processes in order to achieve high filling through underlayer film formation, and desirably also achieve both high planarization and excellent film formability through underlayer film formation, in multilayer lithography using a resist underlayer film. Consequently, the inventors have found that a resist underlayer film material mainly containing a resin with a certain structure and a patterning process using the material are very effective. These findings have led to the completion of the present invention.

Specifically, the present invention provides a resist underlayer film material used in a multilayer resist method, comprising:
(A) a resin having a structural unit shown by the following general formula (1); and
(B) an organic solvent,
   wherein the resin is contained in an amount of 20 mass% or more, 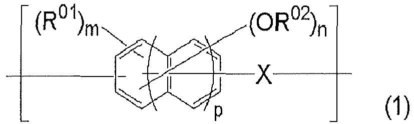
wherein R⁰¹ represents a saturated or unsaturated monovalent organic group having 1 to 30 carbon atoms optionally having a substituent; R⁰² represents a hydrogen atom or a saturated or unsaturated monovalent organic group having 1 to 30 carbon atoms optionally having a substituent, and the structures constituting R⁰² satisfy relations of a+b=1, 0.1≤a≤0.5, and 0.5≤b≤0.9, where "a" represents a proportion of the hydrogen atom, and "b" represents a proportion of the monovalent organic group; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1.

Hereinafter, the present invention will be described in detail, but the present invention is not limited thereto.

### <Resist Underlayer Film Material>

The inventive resist underlayer film material is a resist underlayer film material to be used in a multilayer resist method as described above, and contains: (A) a resin having a structural unit shown by the following general formula (1); and (B) an organic solvent. The resist underlayer film material contains the resin in an amount of 20 mass% or more. 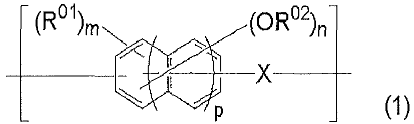 In the general formula (1), R⁰¹ represents a saturated or unsaturated monovalent organic group having 1 to 30 carbon atoms optionally having a substituent. R⁰² represents a hydrogen atom or a saturated or unsaturated monovalent organic group having 1 to 30 carbon atoms optionally having a substituent. The structures constituting R⁰² satisfy relations of a+b=1, 0.1≤a≤0.5, and 0.5≤b≤0.9, where "a" represents a proportion of the hydrogen atom, and "b" represents a proportion of the monovalent organic group. X represents a divalent organic group having 1 to 30 carbon atoms. "m" represents an integer of 0 to 5, "n" represents an integer of 1 to 6, and m+n is an integer of 1 or more and 6 or less. "p" represents 0 or 1.

### [(A) Resin having Structural Unit shown by General Formula (1)]

By incorporating a resin having a structural unit shown by the general formula (1), the inventive resist underlayer film material is excellent in flowability and substrate affinity. Adjusting the proportions of the structures within the ranges makes it possible to achieve both void elimination and peeling inhibition when a substrate to be processed is filled with the material. Meanwhile, if the resin content is less than 20 mass%, a thick resist underlayer film cannot be formed. Thus, the inventive resist underlayer film material is conceivably excellent in filling property and capable of forming a resist underlayer film without causing defects, such as void and peeling, even on a substrate to be processed which has a portion with a large aspect ratio that makes filling particularly difficult.

Examples of the saturated or unsaturated monovalent organic group having 1 to 30 carbon atoms optionally having a substituent represented by R⁰¹ in the general formula (1) include monovalent saturated hydrocarbon groups, such as a methyl group, an ethyl group, an n-propyl group, an i-propyl group, an n-butyl group, an i-butyl group, a sec-butyl group, a tert-butyl group, an n-pentyl group, an iso-pentyl group, a sec-pentyl group, and a tert-pentyl group; monovalent unsaturated open-chain hydrocarbon groups, such as an ethenyl group, a propenyl group, a butenyl group, a pentenyl group, an ethynyl group, and a propynyl group; monocyclic saturated cyclic hydrocarbon groups, such as a cyclobutyl group, a cyclopentyl group, a cyclohexyl group, a cycloheptyl group, and a cyclooctyl group; monovalent monocyclic unsaturated cyclic hydrocarbon groups, such as a cyclobutenyl group, a cyclopentenyl group, and a cyclohexenyl group; monovalent polycyclic cyclic hydrocarbon groups, such as a norbornyl group and an adamantyl group; monovalent aromatic hydrocarbon groups, such as a phenyl group, a methylphenyl group, a naphthyl group, a methylnaphthyl group, an anthryl group, and a methylanthryl group; etc.

The examples of the organic group represented by R⁰¹ further include alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; alkoxycarbonyl groups, such as a methoxycarbonyl group, an ethoxycarbonyl group, an n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group; etc.

These saturated hydrocarbon groups, unsaturated open-chain hydrocarbon groups, monocyclic saturated cyclic hydrocarbon groups, monocyclic unsaturated cyclic hydrocarbon groups, polycyclic cyclic hydrocarbon groups, aromatic hydrocarbon groups, alkoxy groups, alkoxycarbonyl groups, and the like may have some or all of hydrogen atoms substituted. Examples of such substituents include halogen atoms, such as a fluorine atom, a chlorine atom, a bromine atom, and an iodine atom; a hydroxyl group, a cyano group, a carboxy group, a nitro group, an amino group, an alkoxy group, an alkoxycarbonyl group, an acyl group, an alkoxycarbonyloxy group, and an aryl group; aliphatic heterocyclic groups, such as a lactone group; aromatic heterocyclic groups, such as a furyl group and a pyridyl group; etc.

To achieve both favorable filling and planarizing properties, the organic group represented by R⁰¹ is preferably a methyl group.

Examples of the divalent organic group having 1 to 30 carbon atoms represented by X in the general formula (1) include alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (dicyclopentylene group), a tricyclo[3.3.1.1^{3,7}]decanediyl group, a tetracyclo[6.2.1.1^{3,6}.0^{2,7}]dodecanediyl group, and an adamantanediyl group; arenediyl groups, such as a phenylene group and a naphthylene group; etc.

The X may represent an alkanediyloxy group, and examples thereof include groups which are combinations between the aforementioned alkanediyl groups and an oxygen atom; etc. Moreover, the X may represent a cycloalkanediyloxy group, and examples thereof include groups which are combinations between the aforementioned cycloalkanediyl groups and an oxygen atom; etc.

These alkanediyl groups, cycloalkanediyl groups, alkanediyloxy groups, cycloalkanediyloxy groups, arenediyl groups, and the like may have some or all of hydrogen atoms substituted. Examples of such substituents include the same groups exemplified as the substituent which the organic group represented by R⁰¹ may have; etc.

Examples of the organic group represented by X include groups represented by the following formulae, etc. 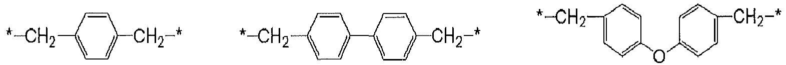 In the formulae, * represents a bonding arm.

To achieve both favorable filling and planarizing properties, the organic group represented by X is preferably a methylene group.

In the general formula (1), R⁰² is a hydrogen atom or a saturated or unsaturated monovalent organic group having 1 to 30 carbon atoms optionally having a substituent. Examples of preferable structures of R⁰² include a hydrogen atom, an alkyl group having 1 to 10 carbon atoms, any of structures shown in the following general formula (2); etc. 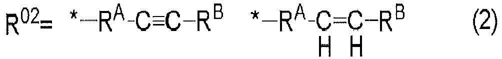 In the formulae, * represents an attachment point to an oxygen atom. R^{A} represents a divalent organic group having 1 to 10 carbon atoms optionally having a substituent. R^{B} represents a hydrogen atom or a monovalent organic group having 1 to 10 carbon atoms optionally having a substituent.

Examples of the divalent organic group having 1 to 10 carbon atoms represented by R^{A} in the general formula (2) include alkanediyl groups, such as a methylene group, an ethanediyl group, a propanediyl group, a butanediyl group, a pentanediyl group, a hexanediyl group, an octanediyl group, and a decanediyl group; arenediyl groups, such as a benzenediyl group, a methylbenzenediyl group, and a naphthalenediyl group; etc.

Examples of the monovalent organic group having 1 to 10 carbon atoms represented by R^{B} in the general formula (2) include alkyl groups, such as a methyl group, an ethyl group, an n-propyl group, an i-propyl group, an n-butyl group, an i-butyl group, a sec-butyl group, a t-butyl group, an n-pentyl group, an n-hexyl group, an n-octyl group, and an n-decyl group; aryl groups, such as a phenyl group, a tolyl group, a xylyl group, a mesityl group, and a naphthyl group; etc.

These alkanediyl groups, arenediyl groups, alkyl groups, aryl groups, and the like may have some or all of hydrogen atoms substituted. Examples of such substituents include the same groups exemplified as the substituent which the organic group represented by R⁰¹ may have; etc.

Particularly preferable examples of R⁰² can include structures shown below. Having such structures makes the flowability favorable, and enhances the filling and planarizing properties. Moreover, the heat resistance and film formability become favorable, sublimation products are suppressed during heat curing, contamination of the apparatus due to the sublimation products is suppressed, and coating defect can be suppressed. 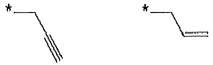 In the formulae, * represents an attachment point to the oxygen atom.

Specific examples of the structure represented by the proportion "b" in the resin having a structural unit shown by the general formula (1) include the following, but are not limited thereto.

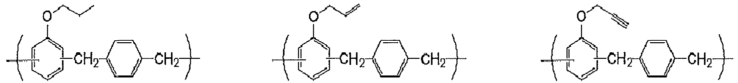

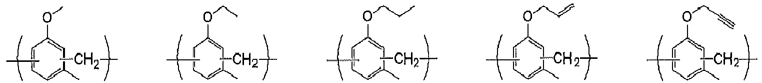

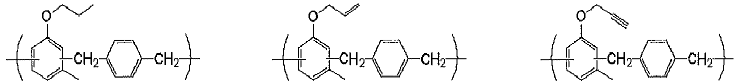

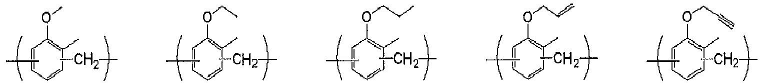

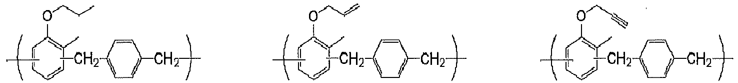

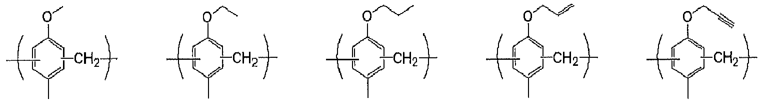

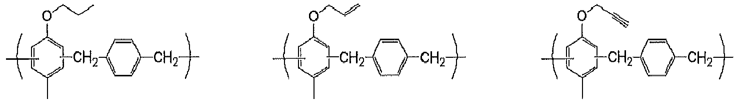

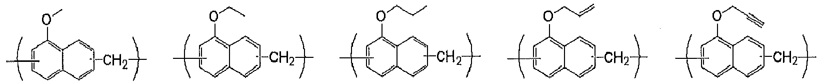

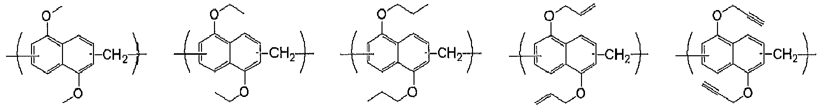

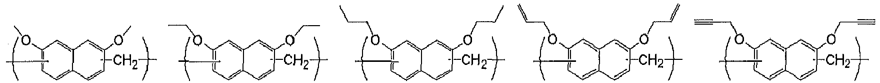

Further, "a" and "b" satisfy the relations of a+b=1, 0.1≤a≤0.5, and 0.5≤b≤0.9, where "a" is the proportion of hydrogen atoms, and "b" is the proportion of monovalent organic groups among the structures constituting R⁰² in the general formula (1). The relations of "a" and "b" are preferably a+b=1, 0.15≤a≤0.4, and 0.6≤b≤0.85. If the proportions of the structures are outside these ranges, both void elimination and peeling inhibition cannot be achieved at the time of filling a substrate to be processed which has a portion with a large aspect ratio, and which is particularly difficult to fill.

Further, in the general formula (1), "p" is 0 or 1, and "n" represents an integer of 1 to 6. Preferably, "p" is 0 and "n" is 1. The resist underlayer film materials containing such structures exhibit quite excellent filling property on a substrate to be processed which has a portion with a large aspect ratio, and which is particularly difficult to fill. Thereby, gap filling is possible without void or peeling.

Further, in the general formula (1), "m" is an integer of 0 to 5, and m+n is an integer of 1 or more and 6 or less.

The resin (A) having a structural unit shown by the general formula (1) preferably has a weight-average molecular weight of 3,000 to 10,000. The weight-average molecular weight is based on a value measured by gel permeation chromatography (tetrahydrofuran solvent, polystyrene standard). The weight-average molecular weight of the resin (A) having a structural unit shown by the general formula (1) is preferably 3,000 to 10,000, more preferably 4,000 to 9,500. When the weight-average molecular weight is 3,000 or more, the film formability is not degraded, and the apparatus will not be contaminated by increase in sublimation products during heat curing. Meanwhile, where the weight-average molecular weight is 10,000 or less, coating defect does not occur, and the planarizing and filling properties are not degraded even if the flowability is degraded.

In the present invention, one kind of the resin (A) having a structural unit shown by the general formula (1) may be used singly, or two or more kinds thereof may be used in mixture. Alternatively, a resin not containing any structural unit shown by the general formula (1) may be mixed and used. The resin that may be mixed together in this case is not particularly limited, and known resins can be used. Specifically, the resin is preferably an acrylic resin, a styrene resin, a phenol resin, a polyether resin, or an epoxy resin.

The inventive resist underlayer film material may be further blended with a different compound or polymer. The blend compound or blend polymer mixed with the resin having a structural unit shown by the general formula (1) serves to improve the film formability by spin-coating and/or the filling property for a stepped substrate. The blend compound or blend polymer is preferably a compound having a phenolic hydroxyl group.

Examples of such materials include novolak resins of phenol, o-cresol, m-cresol, p-cresol, 2, 3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'dimethyl-4,4'-(9H-fluorene-9-ylidene)bisphenol, 2,2'diallyl-4,4'-(9H-fluorene-9-ylidene)bisphenol, 2,2'difluoro-4,4'-(9H-fluorene-9-ylidene)bisphenol, 2,2'diphenyl-4,4'-(9H-fluorene-9-ylidene)bisphenol, 2,2'dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3' - tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalenes such as 1,5-dihydroxynaphthalene, 1,7-dihydroxynaphthalene, and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, limonene, etc.; and polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. It is also possible to blend a naphthol dicyclopentadiene copolymer disclosed in JP 2004-205685 A, a fluorene bisphenol novolak resin disclosed in JP 2005-128509 A, an acenaphthylene copolymer disclosed in JP 2005-250434 A, fullerene having a phenol group disclosed in JP 2006-227391 A, a bisphenol compound and a novolak resin thereof disclosed in JP 2006-293298 A, a novolak resin of an adamantane phenol compound disclosed in JP 2006-285095 A, a bisnaphthol compound and a novolak resin thereof disclosed in JP 2010-122656 A, a fullerene resin compound disclosed in JP 2008-158002 A, etc.

Moreover, phenol compounds shown by the following general formula (2A) or (3A) may be blended. 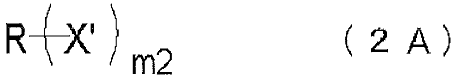 In the formula, R represents a single bond or an organic group having 1 to 50 carbon atoms. X' represents a group shown by the following general formula (2B). m2 represents an integer satisfying 1≤m2≤5. 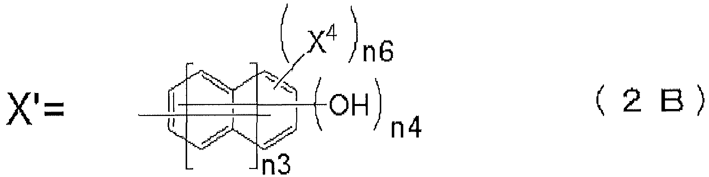 In the formula, n3 represents 0 or 1. n4 represents 1 or 2. X⁴ represents a group shown by the following general formula (2C). n6 represents 0, 1, or 2. 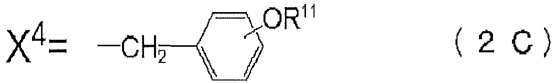 In the formula, R¹¹ represents a hydrogen atom or a saturated or unsaturated hydrocarbon group having 1 to 10 carbon atoms. A hydrogen atom on the benzene ring in the formula is optionally substituted with a methyl group or a methoxy group.

In the general formula (2A), R is a single bond or an organic group having 1 to 50 carbon atoms. X' is a group shown by the general formula (2B). m2 is an integer satisfying 1≤m2≤5.

In the general formula (2B), n3 is 0 or 1. n4 is 1 or 2. X⁴ is a group shown by the general formula (2C). n6 is 0, 1, or 2.

In the general formula (2C), R¹¹ is a hydrogen atom or a saturated or unsaturated hydrocarbon group having 1 to 10 carbon atoms. A hydrogen atom on the benzene ring in the formula may be substituted with a methyl group or a methoxy group. 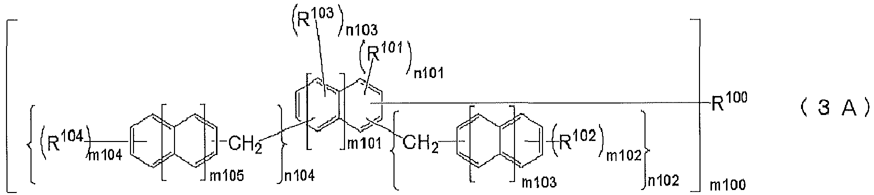 In the formula, R¹⁰¹, R¹⁰², R¹⁰³, and R¹⁰⁴ each independently represent a hydroxyl group. m100 represents 1, 2, or 3. R¹⁰⁰ represents a hydrogen atom or a hydroxyl group when m100 is 1, represents a single bond or any group shown in the following general formula (3B) when m100 is 2, or represents a group shown by the following general formula (3C) when m100 is 3. Hydrogen atoms on aromatic rings in the formula are optionally substituted with a methyl group, a methoxy group, a hydroxymethyl group, or a methoxymethyl group. m101 represents 0 or 1. m102 represents 1 or 2. m103 represents 0 or 1. m104 represents 1 or 2. m105 represents 0 or 1. When m101 is 0, n101 and n102 are integers satisfying 0≤n101≤3, 0≤n102≤3, and 1≤n101+n102≤4. When m101 is 1, n101, n102, n103, and n104 are integers satisfying 0≤n101≤2, 0≤n102≤2, 0≤n103≤2, 0≤n104≤2, and 2≤n101+n102+n103+n104≤8. 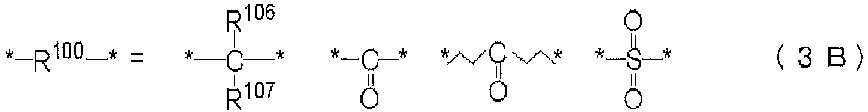 In the formula, * represents an attachment position. R¹⁰⁶ and R¹⁰⁷ each represent a hydrogen atom or an organic group having 1 to 24 carbon atoms. R¹⁰⁶ and R¹⁰⁷ are optionally bonded to each other to form a cyclic structure together with the carbon atom bonded to R¹⁰⁶ and R¹⁰⁷. 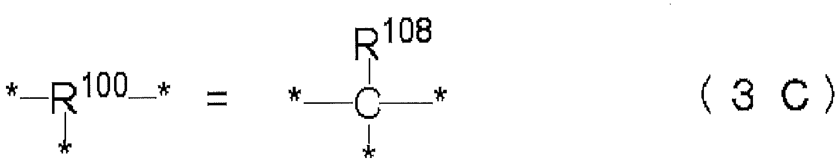 In the formula, * represents an attachment position. R¹⁰⁸ represents a hydrogen atom or an organic group having 1 to 15 carbon atoms.

In the general formula (3A), R¹⁰¹, R¹⁰², R¹⁰³, and R¹⁰⁴ are each independently a hydroxyl group. m100 is 1, 2, or 3. R¹⁰⁰ is a hydrogen atom or a hydroxyl group when m100 is 1, or a single bond or a group shown by the following general formula (3B) when m100 is 2, or a group shown by the following general formula (3C) when m100 is 3. Hydrogen atoms on the aromatic rings in the formula may be substituted with a methyl group, a methoxy group, a hydroxymethyl group, or a methoxymethyl group. m101 is 0 or 1. m102 is 1 or 2. m103 is 0 or 1. m104 is 1 or 2. m105 is 0 or 1. When m101 is 0, n101 and n102 are each an integer satisfying 0≤n101≤3, 0≤n102≤3, and 1≤n101+n102≤4; when m101 is 1, n101, n102, n103, and n104 are each an integer satisfying 0≤n101≤2, 0≤n102≤2, 0≤n103≤2, 0≤n104≤2, and 2≤n101+n102+n103+n104≤8.

In the general formula (3B), * represents an attachment position. R¹⁰⁶ and R¹⁰⁷ are each a hydrogen atom or an organic group having 1 to 24 carbon atoms. R¹⁰⁶ and R¹⁰⁷ may be bonded to each other to form a cyclic structure together with the carbon atom bonded to R¹⁰⁶ and R¹⁰⁷.

In the general formula (3C), * represents an attachment position. R¹⁰⁸ is a hydrogen atom or an organic group having 1 to 15 carbon atoms.

Examples of the compound shown by the general formula (2A) include the following compounds. Note that any hydrogen atom on aromatic rings of the following compounds may be substituted with a methyl group, a methoxy group, a hydroxymethyl group, or a methoxymethyl group.

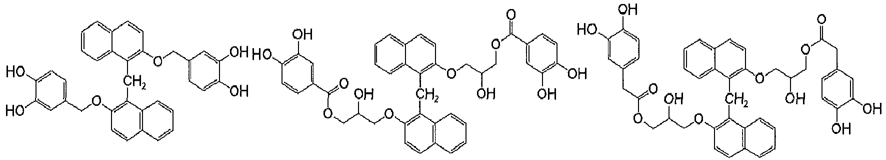

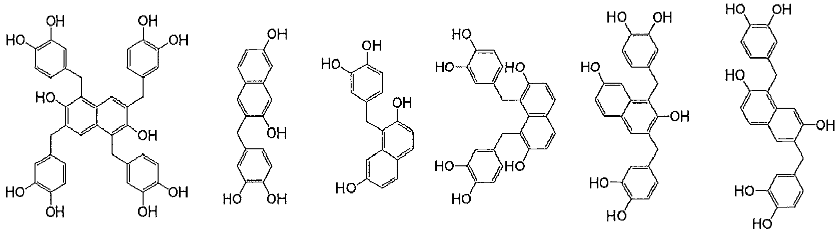

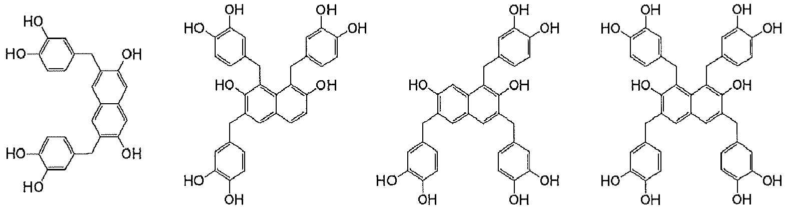

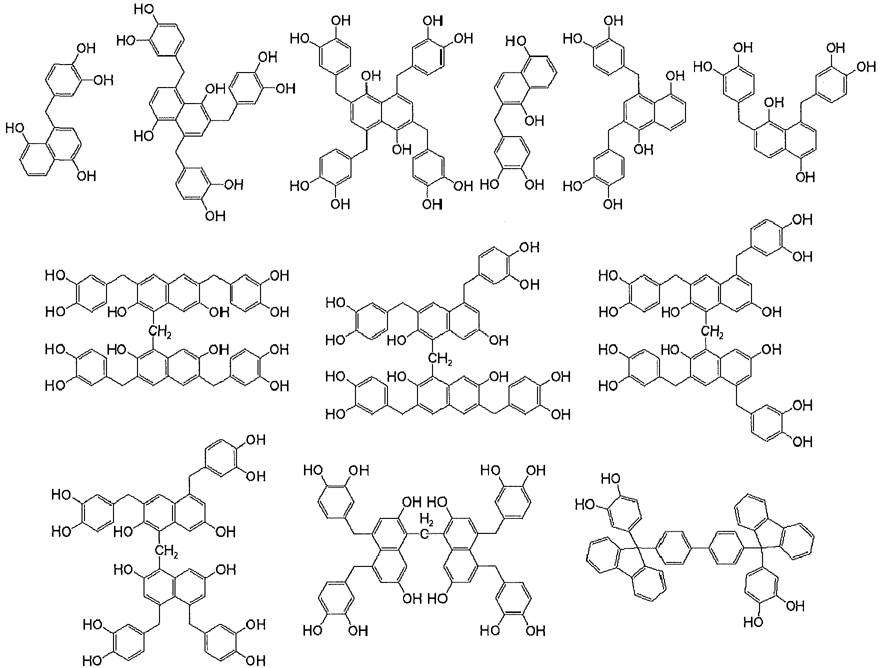

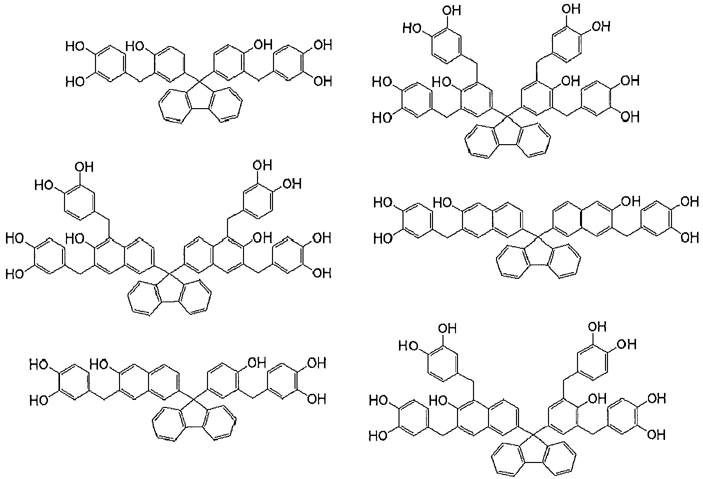

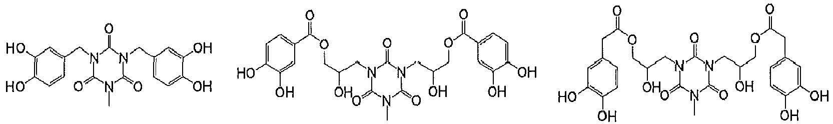

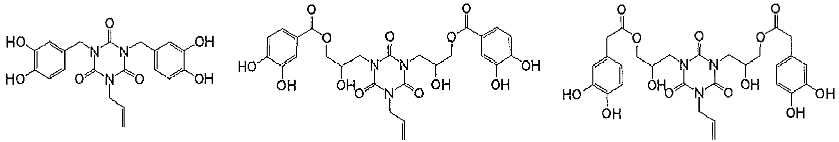

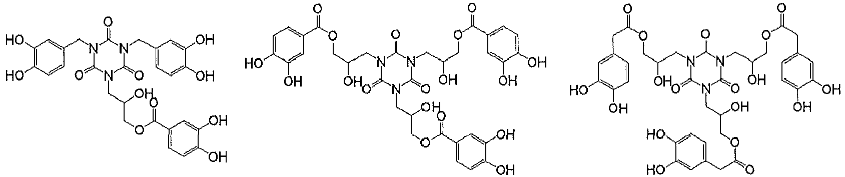

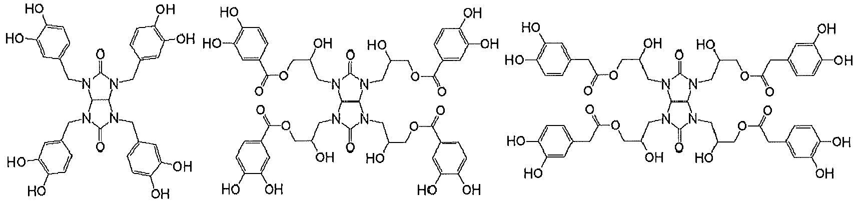

Examples of the compound shown by the general formula (3A) include the following compounds. Note that any hydrogen atom on aromatic rings of the following compounds may be substituted with a methyl group, a methoxy group, a hydroxymethyl group, or a methoxymethyl group.

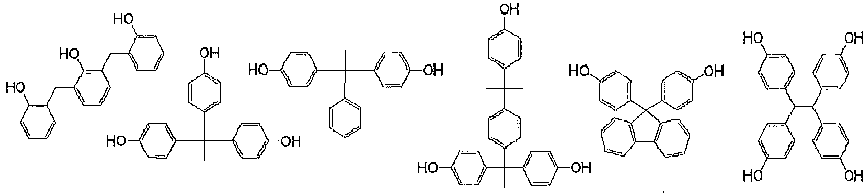

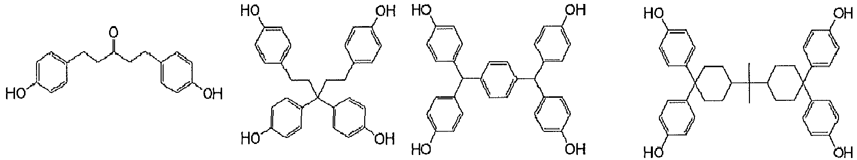

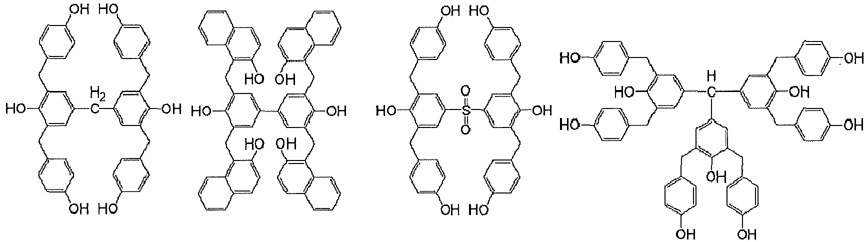

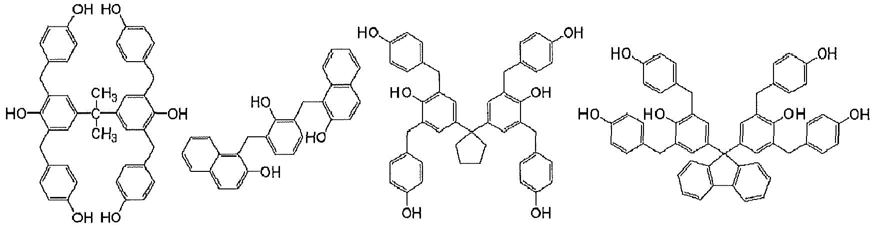

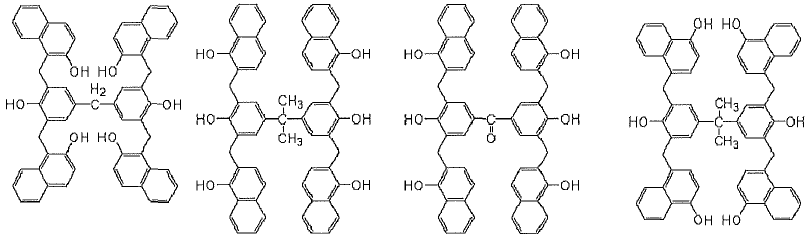

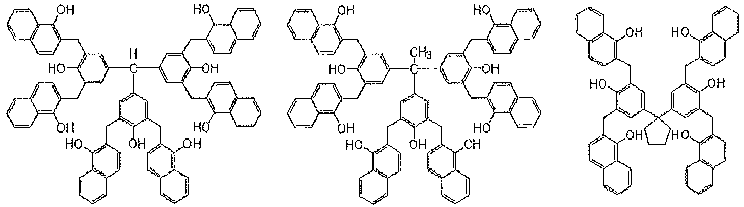

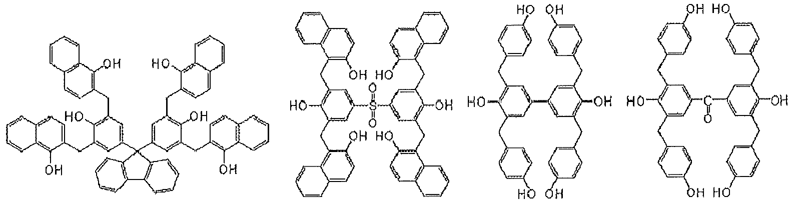

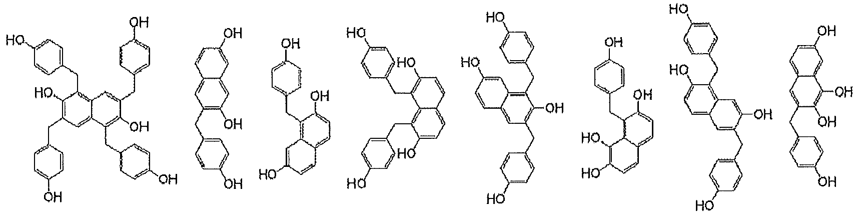

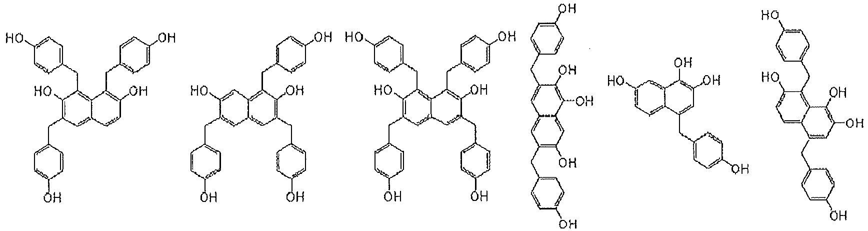

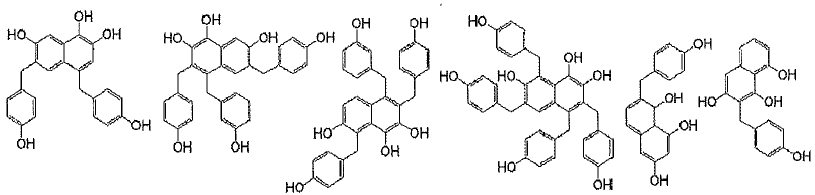

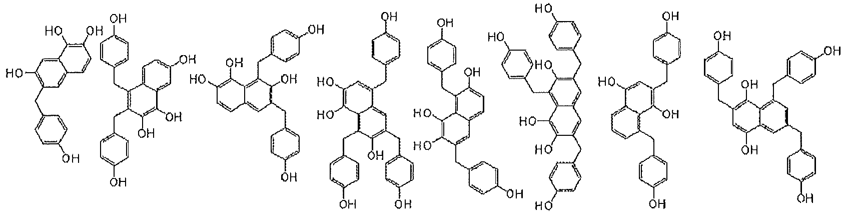

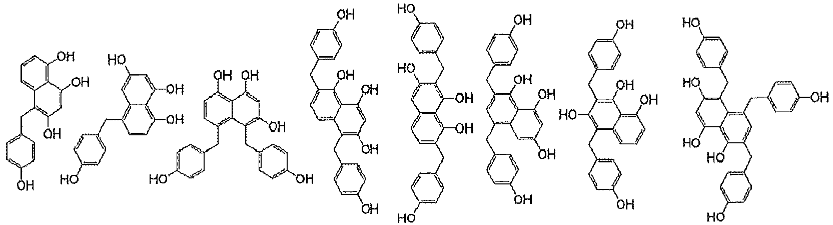

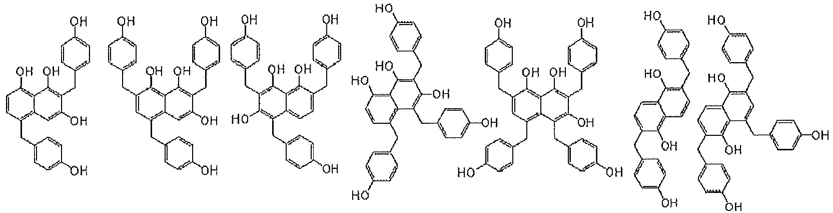

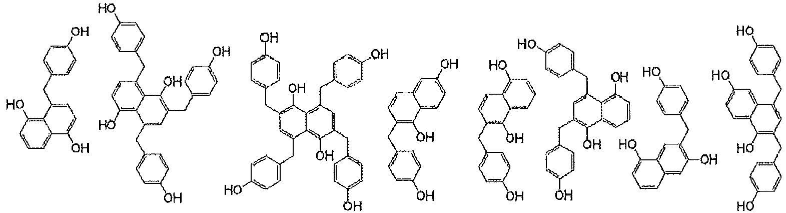

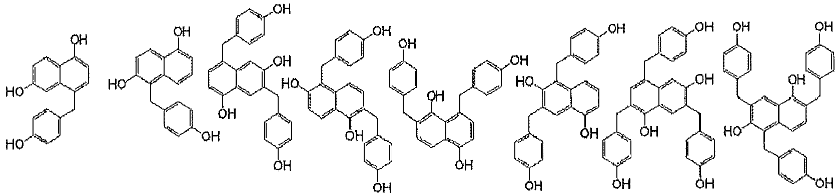

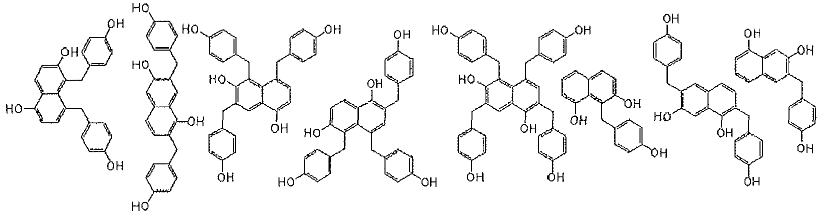

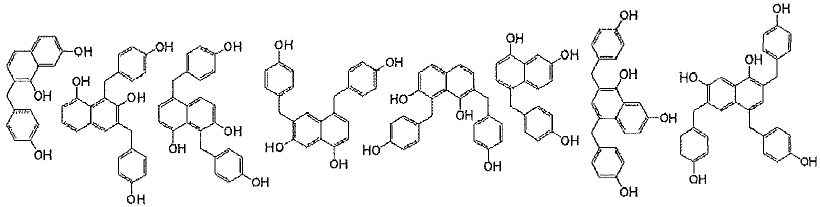

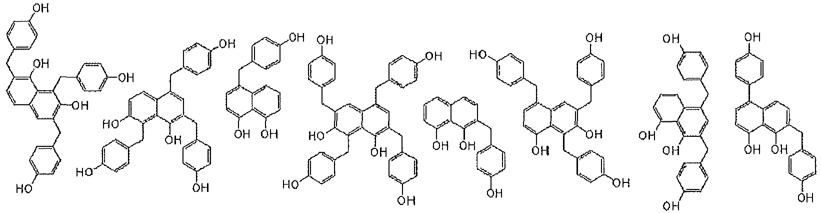

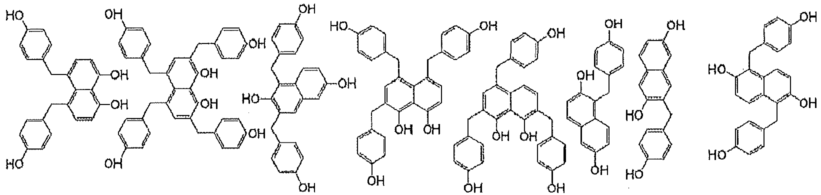

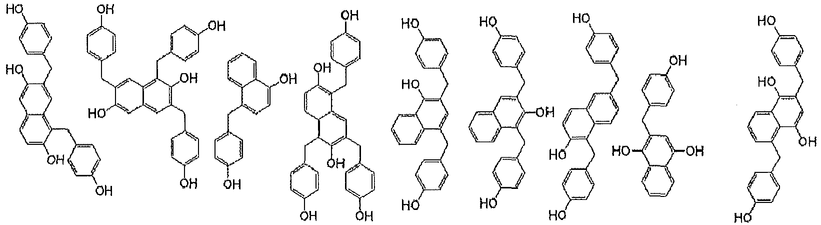

The blendable compound or blendable polymer is blended in an amount of preferably 5 to 100 parts by mass, more preferably 5 to 50 parts by mass, based on 100 parts by mass of the resin (A) having a structural unit shown by the general formula (1).

### [(B) Organic Solvent]

The organic solvent (B) usable in the inventive resist underlayer film material is not particularly limited, as long as it is capable of dissolving the resin (A) having a structural unit shown by the general formula (1). Preferably, the organic solvent (B) is capable of dissolving (C) a crosslinking agent, (D) an acid generator, (E) a surfactant, (F) a plasticizer, and (G) a pigment, which are described later.

Specifically, organic solvents disclosed in paragraphs [0091] to [0092] of JP 2007-199653 A can be added. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture containing one or more of these.

It is desirable to adjust the amount of the organic solvent blended, depending on an intended thickness of the resist underlayer film. Generally, the amount is in a range of 100 to 50,000 parts by mass based on 100 parts by mass of the resin of the general formula (1).

Moreover, in the inventive resist underlayer film material, the organic solvent (B) to be used may be a mixture of: one or more organic solvents each having a boiling point of lower than 180°C; and one or more organic solvents each having a boiling point of 180°C or higher (hereinafter also referred to as "high-boiling-point solvent(s)").

Specific examples of the organic solvents having a boiling point of lower than 180°C can include propylene glycol monomethyl ether acetate, propylene glycol monomethyl ether, propylene glycol monoethyl ether, propylene glycol monopropyl ether, 2-heptanone, cyclopentanone, and cyclohexanone.

The organic solvents having a boiling point of 180°C or higher are not particularly limited to hydrocarbons, alcohols, ketones, esters, ethers, chlorinated solvents, and so forth, as long as the high-boiling-point solvents are capable of dissolving each component of the inventive resist underlayer film material. Specific examples thereof can include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, etc. These may be used singly or in mixture thereof.

The organic solvent(s) having a boiling point of 180°C or higher may be appropriately selected, for example, from the above list according to the temperature at which the inventive resist underlayer film material is heated, etc. The boiling point of the organic solvent(s) having a boiling point of 180°C or higher is preferably 180°C to 300°C, further preferably 200°C to 300°C. Such boiling points presumably prevent the evaporation rate at baking (heating) from becoming too fast, which would otherwise occur if the boiling point is too low. Thus, the boiling points can provide sufficient thermal flowability during the film formation, and a resist underlayer film excellent in filling property and planarizing property can be formed. Moreover, such boiling points are not too high, so that the high-boiling-point solvent(s) evaporate after baking and do not remain in the film; thus, the boiling points do not adversely affect the film physical properties, such as etching resistance.

Moreover, when the organic solvent(s) having a boiling point of 180°C or higher are used, the organic solvent(s) are blended in an amount of preferably 1 to 30 parts by mass based on 100 parts by mass of the organic solvent(s) having a boiling point of lower than 180°C. Such a formulation amount prevents a failure in providing sufficient thermal flowability during baking, which would otherwise occur if the formulation amount is too small. In addition, degradation of the film physical properties such as etching resistance is prevented, which would otherwise occur if the formulation amount is so large that the solvent(s) remain in the film. Thus, such a formulation amount is preferable.

### [(C) Crosslinking Agent]

Moreover, to the inventive resist underlayer film material, a crosslinking agent (C) can also be added so as to increase the curability and to further suppress intermixing with a resist upper layer film. The crosslinking agent is not particularly limited, and known various types of crosslinking agents can be widely used. Examples thereof can include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g., methylolated- or alkoxymethylated polynuclear phenol-based crosslinking agents). When a crosslinking agent is added, the crosslinking agent is added in an amount of preferably 1 to 50 parts by mass, more preferably 10 to 40 parts by mass, based on 100 parts by mass of the resin having a structural unit shown by the general formula (1).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

A specific example of the β-hydroxyalkylamide-based crosslinking agents includes N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis-4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include a compound shown by the following general formula (10). 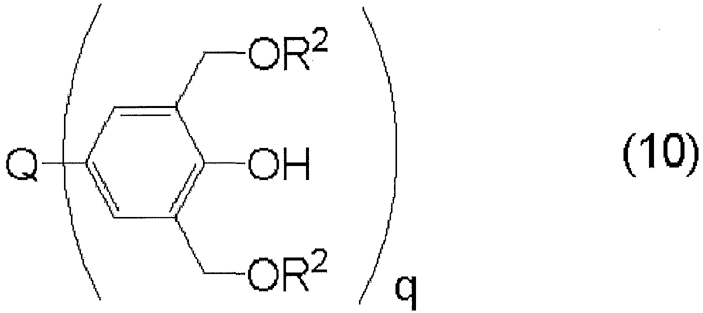 In the formula, Q represents a single bond, or a hydrocarbon group with a valency of "q" having 1 to 20 carbon atoms. R² represents a hydrogen atom, or an alkyl group having 1 to 20 carbon atoms. "q" represents an integer of 1 to 5.

Q is a single bond, or a hydrocarbon group having a valency of "q" and 1 to 20 carbon atoms. "q" is an integer of 1 to 5, more preferably 2 or 3. Specific examples of Q include such groups of methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane from each of which "q" hydrogen atoms are excluded.

R² is a hydrogen atom, or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. R² is preferably a hydrogen atom or a methyl group.

Specific examples of the compound shown by the general formula (10) include the following compounds. Among these, triphenolmethane, triphenolethane, 1,1,1-tris(4-hydroxyphenyl)ethane, and tris(4-hydroxyphenyl)-1-ethyl-4-isopropylbenzene that are subjected to hexamethoxymethylation are preferable from the viewpoints of enhancing the curability and film thickness uniformity of the resist underlayer film. 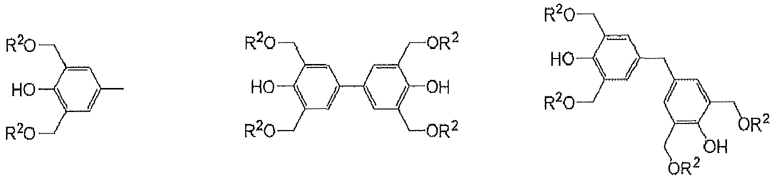 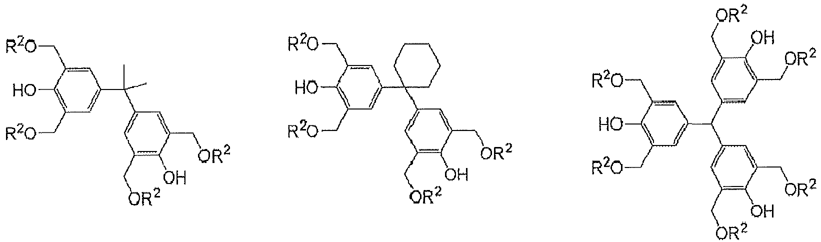 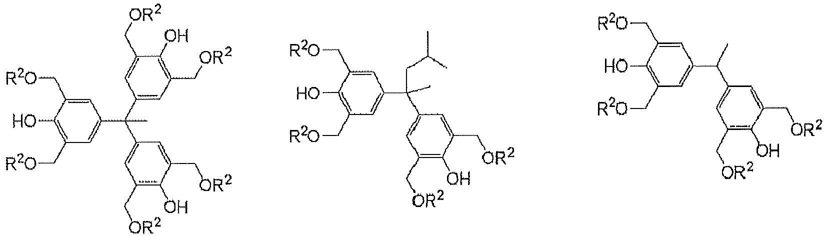 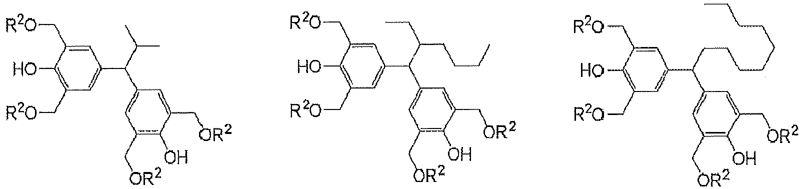 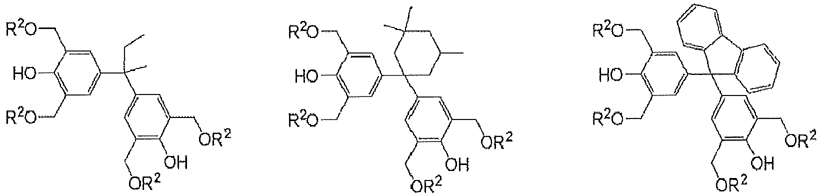 In the formulae, R² is as defined above. 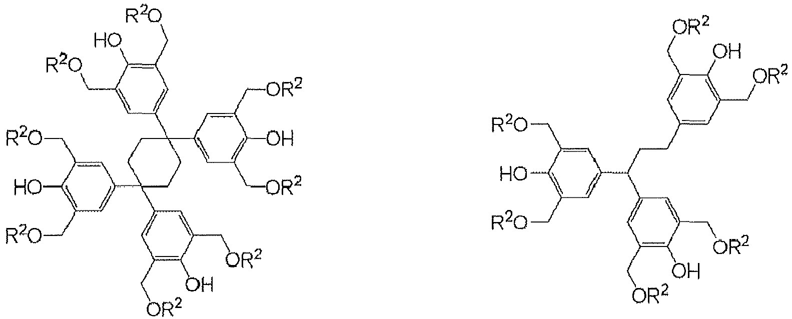 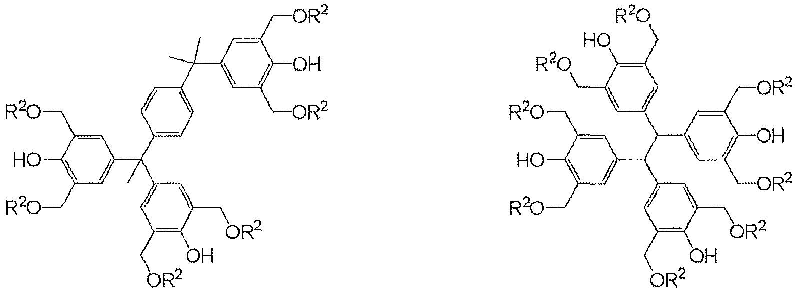 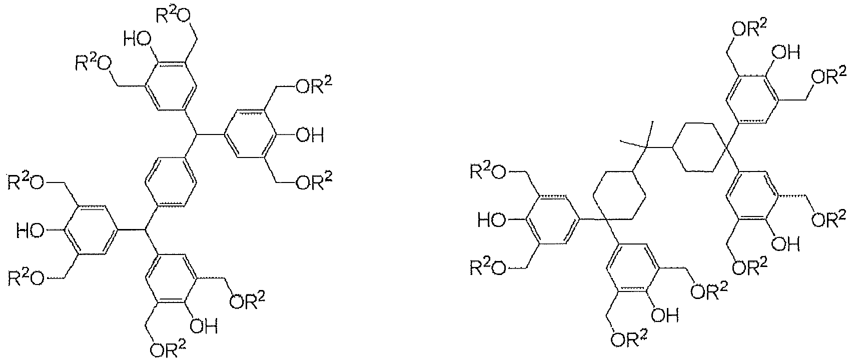 In the formulae, R² is as defined above.

### [(D) Acid Generator]

In the inventive resist underlayer film material, an acid generator (D) can be added so as to further promote the curing reaction. The acid generator a material that generates an acid by thermal decomposition, and a material that generates an acid by light irradiation. Any of these can be added. Specifically, materials disclosed in paragraphs [0061] to [0085] of JP 2007-199653 A can be added, but the present invention is not limited thereto.

One kind of the acid generator can be used singly, or two or more kinds thereof can be used in combination. When an acid generator is added, the acid generator is added in an amount of preferably 0.05 to 50 parts by mass, more preferably 0.1 to 10 parts by mass, based on 100 parts by mass of the resin having a structural unit shown by the general formula (1).

In order to make the filling property more excellent, the acid generator is preferably not added.

### [(E) Surfactant]

To the inventive resist underlayer film material, a surfactant (E) can be added so as to enhance the coating property in spin coating. As the surfactant, for example, those disclosed in [0142] to [0147] of JP 2009-269953 A can be used. Examples thereof include nonionic surfactants, fluorine-based surfactants, etc. When a surfactant is added, the surfactant is added in an amount of preferably 0.001 to 20 parts by mass, more preferably 0.01 to 10 parts by mass, based on 100 parts by mass of the resin having a structural unit shown by the general formula (1).

### [(F) Plasticizer]

Further, to the inventive resist underlayer film material, a plasticizer (F) can be added so as to further enhance planarizing and filling properties. The plasticizer is not particularly limited, and known various types of plasticizers can be widely used. Examples thereof can include low-molecular-weight compounds, such as phthalic acid esters, adipic acid esters, phosphoric acid esters, trimellitic acid esters, and citric acid esters; and polymers, such as polyethers, polyesters, and polyacetal-based polymers disclosed in JP 2013-253227 A. When a plasticizer is added, the plasticizer is added in an amount of preferably 5 to 500 parts by mass, more preferably 10 to 200 parts by mass, based on 100 parts by mass of the resin having a structural unit shown by the general formula (1).

### [(G) Pigment]

Furthermore, to the inventive resist underlayer film material, a pigment (G) can be added so as to further enhance the resolution in multilayer lithography patterning. The pigment is not particularly limited, as long as the compound has appropriate absorption at exposure wavelength, and known various compounds can be widely used. Examples thereof can include benzenes, naphthalenes, anthracenes, phenanthrenes, pyrenes, isocyanuric acids, and triazines. When a pigment is added, the pigment is added in an amount of preferably 0.01 to 10 parts by mass, more preferably 0.1 to 5 parts by mass, based on 100 parts by mass of the resin having a structural unit shown by the general formula (1).

### <Patterning Processes>

Moreover, the present invention provides a patterning process for forming a pattern in a substrate to be processed, the process including steps of:
(I-1) applying the above-described resist underlayer film material onto the substrate to be processed, followed by heating to form a resist underlayer film;
(1-2) forming a resist upper layer film on the resist underlayer film by using a photoresist material;
(1-3) subjecting the resist upper layer film to pattern exposure and then development with a developer to form a pattern in the resist upper layer film;
(1-4) transferring the pattern to the resist underlayer film by dry etching while using the resist upper layer film having the formed pattern as a mask; and
(1-5) processing the substrate to be processed while using the resist underlayer film having the formed pattern as a mask to form the pattern in the substrate to be processed (2-layer resist process).

Further, the present invention provides a patterning process for forming a pattern in a substrate to be processed, the process including steps of:
(II-1) applying the above-described resist underlayer film material onto the substrate to be processed, followed by heating to form a resist underlayer film;
(II-2) forming a silicon-containing resist middle layer film on the resist underlayer film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the resist underlayer film by dry etching while using the silicon-containing resist middle layer film having the transferred pattern as a mask; and
(II-7) processing the substrate to be processed while using the resist underlayer film having the formed pattern as a mask to form the pattern in the substrate to be processed (3-layer resist process).

In addition, the present invention provides a patterning process for forming a pattern in a substrate to be processed, the process including steps of:
(III-1) applying the above-described resist underlayer film material onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed (4-layer resist process).

The thickness of the resist underlayer film utilized in the present invention is appropriately selected, and is preferably 1,000 to 20,000 nm, particularly preferably 1,500 to 15,000 nm. When the resist underlayer film is used for 3-layer process, a silicon-containing resist middle layer film containing silicon and a resist upper layer film containing no silicon can be formed thereon. When the resist underlayer film is used for 2-layer process, a resist upper layer film containing silicon or a resist upper layer film containing no silicon can be formed thereon.

The patterning processes according to the present invention are suitably employed in multilayer resist processes: silicon-involving 2-layer resist process; 3-layer resist process using a silicon-containing resist middle layer film; 4-layer resist process using an inorganic hard mask middle layer film and an organic thin film; or silicon-free 2-layer resist process.

### [3-Layer Resist Process]

Hereinbelow, the inventive patterning processes will be described by illustrating a 3-layer resist process as an example, but are not limited to this process. In this case, the above-described resist underlayer film material is used to form a resist underlayer film on a substrate. On the resist underlayer film, a silicon-containing resist middle layer film is formed using a silicon-containing resist middle layer film material containing silicon atoms. On the silicon-containing resist middle layer film, a resist upper layer film is formed using a resist upper layer film material as a photoresist composition, so that a multilayer resist film is formed. A pattern circuit region of the resist upper layer film is subjected to exposure and then development with a developer to form a resist pattern in the resist upper layer film. Using the pattern-formed resist upper layer film as a mask, the silicon-containing resist middle layer film is etched. Using the pattern-formed silicon-containing resist middle layer film as a mask, the resist underlayer film is etched. Further, using the pattern-formed resist underlayer film as a mask, the substrate is processed. In this manner, the pattern can be formed in the substrate.

The silicon-containing resist middle layer film containing silicon atoms exhibits resistance to etching with an oxygen gas or a hydrogen gas. Thus, when the resist underlayer film is etched as described above using the silicon-containing resist middle layer film as the mask, an etching gas mainly containing an oxygen gas or a hydrogen gas is preferably used for the etching.

Moreover, according to the inventive patterning process, a pattern can be formed in a substrate as follows. Specifically, at least, a substrate is prepared to have: a resist underlayer film formed thereon by using the above-described resist underlayer film material; an inorganic hard mask middle layer film selected from a silicon oxide film, a silicon nitride film, and a silicon oxynitride film, and formed on the resist underlayer film; and a resist upper layer film formed on the inorganic hard mask middle layer film by using a resist upper layer film material as a photoresist composition. A pattern circuit region of the resist upper layer film is subjected to exposure and development with a developer to form a resist pattern in the resist upper layer film. Using the obtained resist pattern as an etching mask, the inorganic hard mask middle layer film is etched. Using the resulting inorganic hard mask middle layer film pattern as an etching mask, the resist underlayer film is etched. Using the resulting resist underlayer film pattern as a mask, the substrate is processed to thus pattern the substrate.

In the case where an inorganic hard mask middle layer film is formed on the resist underlayer film as described above, a silicon oxide film, a silicon nitride film, and a silicon oxynitride film (SiON film) can be formed by a CVD method, an ALD method, or the like. The method for forming the nitride film is disclosed in JP 2002-334869 A and WO 2004/066377 A1. The film thickness of the inorganic hard mask is preferably 5 to 3,000 nm, more preferably 10 to 2,000 nm. Above all, a SiON film is the most effective as an antireflective coating and is most preferably used in ArF exposure application.

As the silicon-containing resist middle layer film in the 3-layer resist process, a polysilsesquioxane-based middle layer film can be used suitably. The polysilsesquioxane-based middle layer film is readily provided with an antireflective effect in excimer exposure. Thereby, there are such advantages of satisfactorily suppressing reflection light in pattern exposure of the resist upper layer film, and achieving excellent resolution. Particularly, for 193-nm light exposure, if a material containing many aromatic groups is used as a resist underlayer film, the k-value and thus the substrate reflection are increased. However, the reflection can be suppressed by the silicon-containing resist middle layer film, and so the substrate reflection can be reduced to 0.5% or less. As the silicon-containing resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a silicon-containing resist middle layer film by a spin-coating method is simpler and more advantageous regarding cost than a CVD method.

The resist upper layer film in the 3-layer resist film may be a positive type or a negative type, and any generally-used photoresist composition can be employed. When the resist upper layer film is formed from the photoresist composition, a spin-coating method is preferably employed as in the case of forming the resist underlayer film. After spin-coating of the photoresist composition, pre-baking is preferably performed at 60 to 180°C for 10 to 300 seconds. Then, light exposure, post-exposure bake (PEB), and development are performed according to conventional methods to obtain the resist pattern. Note that the thickness of the resist upper layer film is not particularly limited, but is preferably 10 to 500 nm, and 20 to 400 nm is particularly preferable.

Additionally, examples of exposure light can include a high-energy beam with a wavelength of 300 nm or less, specifically, excimer laser of 248 nm, 193 nm, and 157 nm, soft X-ray of 3 to 20 nm, electron beam, X-ray, etc.

Next, etching is performed using the obtained resist pattern as a mask. In the 3-layer process, the silicon-containing resist middle layer film can be etched using a fluorocarbon-based gas and using the resist pattern as the mask. Then, the resist underlayer film is etched using an oxygen gas or a hydrogen gas and using the silicon-containing resist middle layer film pattern as the mask.

Subsequently, the substrate to be processed can be etched according to a conventional method. For example, the substrate made of SiO₂, SiN, or silica-based low-dielectric insulating film is etched mainly with a fluorocarbon-based gas; and p-Si, Al, or W is etched mainly with a chlorine- or bromine-based gas. When the substrate is processed by etching with a fluorocarbon-based gas, the silicon-containing resist middle layer film in the 3-layer process is removed when the substrate is processed. When the substrate is etched with a chlorine- or bromine-based gas, the silicon-containing resist middle layer film needs to be removed by, for example, additional dry etching with a fluorocarbon-based gas after the substrate processing.

Note that as the substrate to be processed, a layer to be processed may be formed on a substrate. The substrate is not particularly limited, and examples thereof include substrates made of Si, α-Si, p-Si, SiO₂, SiN, SiON, W, TiN, Al, or the like. However, the material different from that of the layer to be processed is selected. Examples of the layer to be processed include: various Low-k films made of Si, SiO₂, SiON, SiN, p-Si, α-Si, W, TiN, W-Si, Al, Cu, Al-Si, or the like; and stopper films thereof. The layer is formed to have a thickness of generally 50 to 15,000 nm, in particular, 100 to 10,000 nm.

The inventive patterning processes are suitable for processing a stepped substrate having a structure or step with an aspect ratio of 10 or more as the substrate to be processed. On such a stepped substrate, the inventive resist underlayer film is formed to fill and planarize the substrate. This enables the silicon-containing resist middle layer film and the resist upper layer film formed thereafter to have uniform film thicknesses. Thus, exposure depth margin (depth of focus: DOF) in photolithography is readily secured and very preferable.

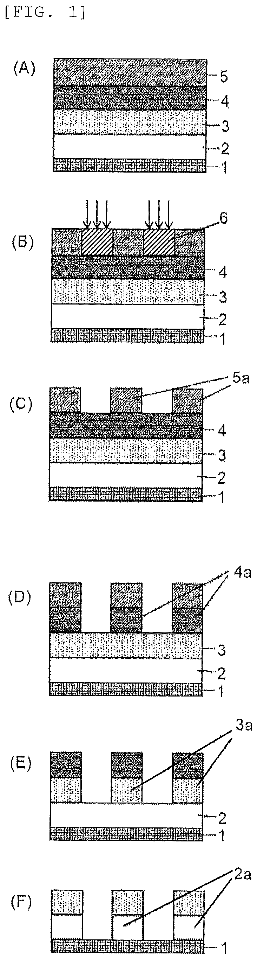

Hereinbelow, an example of the 3-layer resist process will be specifically described with reference to FIG. 1. As shown in FIG. 1 (A), in the 3-layer resist process, a resist underlayer film 3 is formed on a layer 2 to be processed that has been stacked on a substrate 1. Then, a silicon-containing resist middle layer film 4 is formed, and a resist upper layer film 5 is formed thereon.

Next, as shown in FIG. 1 (B), an exposure portion 6 of the resist upper layer film is exposed to light, followed by PEB (baking after exposure) and development to form a resist upper layer film pattern 5a (FIG. 1 (C)). While using the obtained resist upper layer film pattern 5a as a mask, the silicon-containing resist middle layer film 4 is etched with a CF-based gas. Thereby, a silicon-containing resist middle layer film pattern 4a is formed (FIG. 1 (D)). After the resist upper layer film pattern 5a is removed, the resist underlayer film 3 is etched with oxygen or hydrogen plasma while using the obtained silicon-containing resist middle layer film pattern 4a as a mask. Thereby, a resist underlayer film pattern 3a is formed (FIG. 1 (E)). Further, after the silicon-containing resist middle layer film pattern 4a is removed, the layer 2 to be processed is etched while using the resist underlayer film pattern 3a as a mask. Thus, a pattern 2a is formed on the substrate (FIG. 1 (F)).

When an inorganic hard mask middle layer film is used, the silicon-containing resist middle layer film 4 is the inorganic hard mask middle layer film, and when an organic thin film is formed, the organic thin film layer is disposed between the silicon-containing resist middle layer film 4 and the resist upper layer film 5. The etching of the organic thin film may be performed continuously before the etching of the silicon-containing resist middle layer film 4. Alternatively, after the organic thin film is etched alone, the etching apparatus is changed, for example, and then the silicon-containing resist middle layer film 4 may be etched.

### [4-Layer Resist Process]

Furthermore, the present invention is suitably applicable to a 4-layer resist process using an organic thin film. In this case, at least, a substrate is prepared to have: a resist underlayer film formed thereon by using the above-described resist underlayer film material; an inorganic hard mask middle layer film selected from a silicon oxide film, a silicon nitride film, and a silicon oxynitride film, and formed on the resist underlayer film; an organic thin film formed on the inorganic hard mask middle layer film; and a resist upper layer film formed on the organic thin film by using a resist upper layer film material as a photoresist composition. A pattern circuit region of the resist upper layer film is subjected to exposure and then development with a developer to form a resist upper layer film pattern in the resist upper layer film. Using the obtained resist upper layer film pattern as an etching mask, the organic thin film and the inorganic hard mask middle layer film are etched. Using the resulting inorganic hard mask middle layer film pattern as an etching mask, the resist underlayer film is etched. Using the resulting resist underlayer film pattern as a mask, the substrate is processed, so that the pattern can be formed in the substrate.

On the inorganic hard mask middle layer film, a photoresist film may be formed as the resist upper layer film. Alternatively, after an organic thin film is formed on the inorganic hard mask middle layer film as described above by spin coating, the photoresist film may be formed on the organic thin film. When a SiON film is used as the inorganic hard mask middle layer film and an organic antireflective coating (BARC) having a light-absorbing group at the exposure wavelength is used as the organic thin film, the two layers of antireflective coating including the SiON film and the organic thin film in excimer exposure make it possible to suppress the reflection even in liquid immersion exposure at a high NA exceeding 1.0. Another advantage in forming the organic thin film is having an effect of reducing footing of the photoresist pattern immediately above the SiON film. Moreover, when an adhesion film (ADL) having excellent affinity to the upper layer photoresist is used as the organic thin film, there is also such an advantage that pattern collapse of the photoresist can be suppressed.

### <Methods for Forming Resist Underlayer Film>

The present invention provides a method for forming a resist underlayer film that serves as an organic filling film employed in a semiconductor device manufacturing process, the method including:
spin-coating a substrate to be processed with the above-described resist underlayer film material; and
heating the substrate to be processed coated with the resist underlayer film material at a temperature of 100°C or higher and 600°C or lower for 10 to 600 seconds to form a cured film.

The present invention also provides a method for forming a resist underlayer film that serves as an organic filling film employed in a semiconductor device manufacturing process, the method including:
spin-coating a substrate to be processed with the above-described resist underlayer film material; and
heating the substrate to be processed coated with the resist underlayer film material under an atmosphere with an oxygen concentration of 1% or more and 21% or less to form a cured film.

Alternatively, the present invention provides a method for forming a resist underlayer film that serves as an organic filling film employed in a semiconductor device manufacturing process, the method including:
spin-coating a substrate to be processed with the above-described resist underlayer film material; and
heating the substrate to be processed coated with the resist underlayer film material under an atmosphere with an oxygen concentration of less than 1% to form a cured film.

In the inventive methods for forming a resist underlayer film, a substrate to be processed is coated with the above-described resist underlayer film material by a spin-coating method etc. By employing a method like spin-coating method, favorable filling property can be obtained. After the spin-coating, baking is performed to evaporate the solvent and to promote the crosslinking reaction, thereby preventing the mixing with a resist upper layer film or a silicon-containing resist middle layer film. The baking is performed in a temperature range of preferably 100°C or higher to 600°C or lower, more preferably 100°C or higher to 400°C or lower, further preferably 150°C or higher to 350°C or lower. The baking time is in a range of preferably 10 seconds to 600 seconds, more preferably 10 to 300 seconds. Appropriately adjusting the baking temperature and time within the above ranges can make planarizing, filling, and curing properties suitable for use. With the baking temperature at 100°C or higher, curing proceeds sufficiently, preventing mixing with a resist upper layer film or silicon-containing resist middle layer film. With the baking temperature at 600°C or lower, not only thermal decomposition of the base resin but also the film thickness reduction can be suppressed, and the film surface becomes uniform.

As the atmosphere during baking, any of oxygen-containing atmosphere (oxygen concentration: 1% to 21%), as in air, and oxygen-free atmosphere, as in nitrogen, can be selected as necessary. For example, if a substrate to be processed is susceptible to oxidation in air, the substrate damage can be suppress by forming a cured film through heating under an atmosphere with an oxygen concentration of less than 1%.

Moreover, in the inventive methods for forming a resist underlayer film, a substrate having a structure or step with an aspect ratio of 10 or more is preferably used as the substrate to be processed. The inventive methods for forming a resist underlayer film are particularly useful when a void-free flat organic film is formed particularly on a substrate having a structure or step with an aspect ratio of 10 or more.

### EXAMPLE

Hereinafter, the present invention will be specifically described with reference to Examples and Comparative Examples. However, the present invention is not limited to these descriptions. Note that molecular weight and dispersity were measured by the following methods. Weight-average molecular weight (Mw) and dispersity (Mw/Mn) were determined in terms of polystyrene by gel permeation chromatography (GPC) using tetrahydrofuran as an eluent.

Resins (X-1) to (X-16) for resist underlayer film materials and Resins (R-2) to (R-4) for Comparative Examples were synthesized by using the following Resin raw materials (B-1) to (B-6) to synthesize intermediate Resins (A-1) to (A-6), and using Modification agents (C-1) to (C-3) to control the reaction rates. Note that regarding Resin (R-1) for Comparative Example, Resin (A-3) was used as Resin (R-1) for Comparative Example. Note that Resin raw material (B-6) was used as a raw material which was in the form of a 37% aqueous solution.

### Resin raw materials:

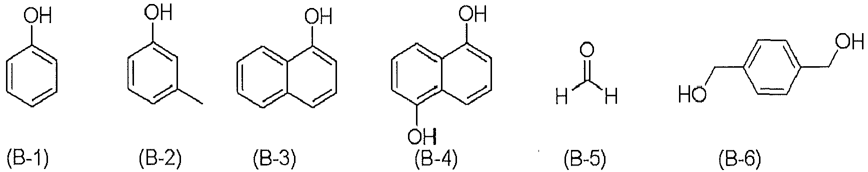

Resins used as intermediates:

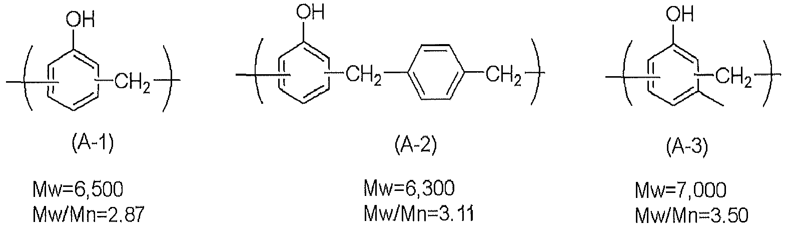

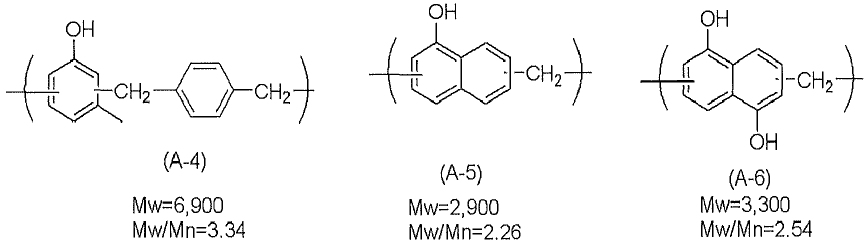

### Modification agents:

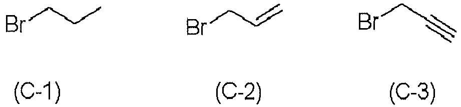

Resins (A-1) to (A-6) illustrated above were synthesized as follows.

### (Synthesis Example A-1)

### Synthesis of Resin (A-1)

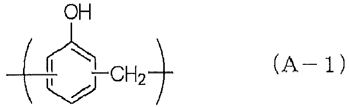

Under nitrogen atmosphere, 188.2 g of Resin raw material (B-1), 113.6 g of Resin raw material (B-5), 9.0 g of oxalic acid, and 100 g of dioxane were added together, and the reaction was allowed to proceed with an inner temperature of 100°C for 24 hours. After completion of the reaction, the resultant was cooled to room temperature, mixed with 2,000 ml of MIBK, and washed six times with 500 ml of pure water. The organic layer was collected, the pressure was reduced to 2 mmHg with an inner temperature of 150°C, and the water, solvent, and remaining monomer were removed under reduced pressure. Thus, Resin (A-1) was obtained.

When the weight-average molecular weight (Mw) and dispersity (Mw/Mn) were determined by GPC, the following results were obtained.
(A-1): Mw=6,500, Mw/Mn=2.87

### (Synthesis Example A-2)

### Synthesis of Resin (A-2)

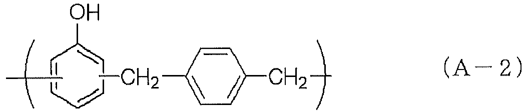

Under nitrogen atmosphere, 94.1 g of Resin raw material (B-1), 89.8 g of Resin raw material (B-6), and 400 g of dichloromethane were added together to prepare a homogeneous dispersion with an inner temperature of 30°C. Then, 211 g of methanesulfonic acid was added thereto over 2 hours, and the reaction was allowed to proceed with the inner temperature of 30°C for 24 hours. After completion of the reaction, the resultant was cooled to room temperature, mixed with 2,000 ml of MIBK, and washed six times with 500 ml of pure water. The organic layer was dried under reduced pressure. To the residue, 300 g of THF was added and a homogeneous solution was prepared. Subsequently, a crystal was precipitated in 2,000 g of hexane. The precipitated crystal was separated by filtration, washed twice with 500 g of hexane, and collected. The collected crystal was vacuum dried at 70°C. Thus, Resin (A-2) was obtained.

When the weight-average molecular weight (Mw) and dispersity (Mw/Mn) were determined by GPC, the following results were obtained.
(A-2): Mw=6,300, Mw/Mn=3.11

### (Synthesis Example A-3)

### Synthesis of Resin (A-3)

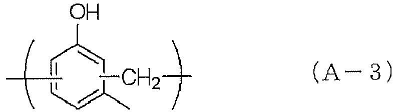

Under nitrogen atmosphere, 216.3 g of Resin raw material (B-2), 113.6 g of Resin raw material (B-5), 10.8 g of oxalic acid, and 200 g of dioxane were added together, and the reaction was allowed to proceed with an inner temperature of 100°C for 24 hours. After completion of the reaction, the resultant was cooled to room temperature, mixed with 2,000 ml of MIBK, and washed six times with 500 ml of pure water. The organic layer was collected, the pressure was reduced to 2 mmHg with an inner temperature of 150°C, and the water, solvent, and remaining monomer were removed under reduced pressure. Thus, Resin (A-3) was obtained.

When the weight-average molecular weight (Mw) and dispersity (Mw/Mn) were determined by GPC, the following results were obtained.
(A-3): Mw=7,000, Mw/Mn=3.50

### (Synthesis Example A-4)

### Synthesis of Resin (A-4)

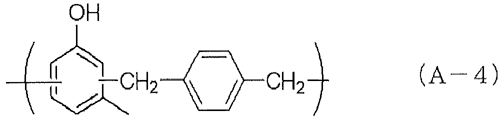

Under nitrogen atmosphere, 108.2 g of Resin raw material (B-2), 89.8 g of Resin raw material (B-6), and 400 g of dichloromethane were added together to prepare a homogeneous dispersion with an inner temperature of 30°C. Then, 211 g of methanesulfonic acid was added thereto over 2 hours, and the reaction was allowed to proceed with the inner temperature of 30°C for 24 hours. After completion of the reaction, the resultant was cooled to room temperature, mixed with 2,000 ml of MIBK, and washed six times with 500 ml of pure water. The organic layer was dried under reduced pressure. To the residue, 300 g of THF was added and a homogeneous solution was prepared. Subsequently, a crystal was precipitated in 2,000 g of hexane. The precipitated crystal was separated by filtration, washed twice with 500 g of hexane, and collected. The collected crystal was vacuum dried at 70°C. Thus, Resin (A-4) was obtained.

When the weight-average molecular weight (Mw) and dispersity (Mw/Mn) were determined by GPC, the following results were obtained.
(A-4): Mw=6,900, Mw/Mn=3.34

### (Synthesis Example A-5)

### Synthesis of Resin (A-5)

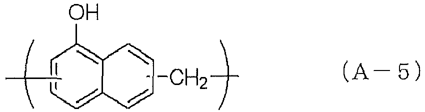

Under nitrogen atmosphere, 144.2 g of Resin raw material (B-3), 56.8 g of Resin raw material (B-5), and 300 g of PGME (propylene glycol monomethyl ether) were added together and homogenized with an inner temperature of 100°C. Then, a homogeneous mixture solution prepared in advance by mixing 7.1 g of p-toluenesulfonic acid monohydrate and 7.1 g of PGME was slowly added dropwise thereto, and the reaction was allowed to proceed with the inner temperature of 100°C for 8 hours. After completion of the reaction, the resultant was cooled to room temperature, mixed with 2,000 ml of MIBK, and washed six times with 500 ml of pure water. The organic layer was dried under reduced pressure. To the residue, 300 g of THF was added and a homogeneous solution was prepared. Subsequently, a crystal was precipitated in 2,000 g of hexane. The precipitated crystal was separated by filtration, washed twice with 500 g of hexane, and collected. The collected crystal was vacuum dried at 70°C. Thus, Resin (A-5) was obtained.

When the weight-average molecular weight (Mw) and dispersity (Mw/Mn) were determined by GPC, the following results were obtained.
(A-5): Mw=2,900, Mw/Mn=2.26

### (Synthesis Example A-6)

### Synthesis of Resin (A-6)

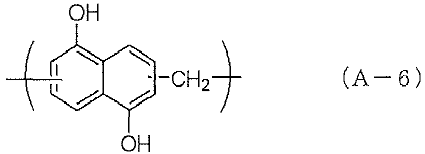

Under nitrogen atmosphere, 160.2 g of Resin raw material (B-4), 56.8 g of Resin raw material (B-5), and 300 g of PGME (propylene glycol monomethyl ether) were added together and homogenized with an inner temperature of 100°C. Then, a homogeneous mixture solution prepared in advance by mixing 8.0 g of p-toluenesulfonic acid monohydrate and 8.0 g of PGME was slowly added dropwise thereto, and the reaction was allowed to proceed with the inner temperature of 80°C for 8 hours. After completion of the reaction, the resultant was cooled to room temperature, mixed with 2,000 ml of MIBK, and washed six times with 500 ml of pure water. The organic layer was dried under reduced pressure. To the residue, 300 g of THF was added and a homogeneous solution was prepared. Subsequently, a crystal was precipitated in 2,000 g of hexane. The precipitated crystal was separated by filtration, washed twice with 500 g of hexane, and collected. The collected crystal was vacuum dried at 70°C. Thus, Resin (A-6) was obtained.

When the weight-average molecular weight (Mw) and dispersity (Mw/Mn) were determined by GPC, the following results were obtained.
(A-6): Mw=3,300, Mw/Mn=2.54

### Synthesis of Resins (X-1) to (X-16) and Resins (R-2) to (R-4) for Comparative Examples

### [Synthesis Example 1] Synthesis of Resin (X-1)

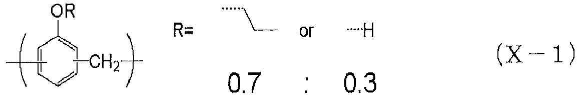

Under nitrogen atmosphere, 20.0 g of Resin (A-1), 31.3 g of potassium carbonate, and 100 g of DMF were added together to prepare a homogeneous dispersion with an inner temperature of 50°C. Then, 16.2 g of Modification agent (C-1) was slowly added thereto, and the reaction was allowed to proceed with the inner temperature of 50°C for 24 hours. To the reaction solution, 300 ml of methyl isobutyl ketone and 300 g of pure water were added to dissolve the deposited salt. Subsequently, the separated aqueous layer was removed. Further, the organic layer was washed six times with 100 g of a 3% nitric acid aqueous solution and 100 g of pure water. Thereafter, the organic layer was dried under reduced pressure. Thus, Resin (X-1) was obtained.

When the weight-average molecular weight (Mw) and dispersity (Mw/Mn) were determined by GPC, the following results were obtained.
(X-1): Mw=8,200, Mw/Mn=2.93

### [Synthesis Examples 2 to 20] Synthesis of Resins (X-2) to (X-16), and Resins (R-2) to (R-4) for Comparative Examples

Resins (X-2) to (X-16) and Resins (R-2) to (R-4) for Comparative Examples shown in Tables 1 to 3 were obtained as products under the same reaction conditions as those in Synthesis Example 1, except that Resin (A-1) to (A-6), Modification agents (C-1) to (C-3), and potassium carbonate were used according to the formulation amounts shown in Tables 1 to 3. The weight-average molecular weight (Mw) and dispersity (Mw/Mn) of each of these resins were determined and shown in Table 4. Those of (X-1) and (R-1) are also shown together.

**[Table 1]**

| Synthesis Example | Resin | Modification agent | Potassium carbonate | Product |
|---|---|---|---|---|
| 1 | A-1: 20.0g | C-1: 16.2g | 31.3g | 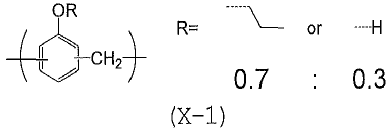 |
| 2 | A-1: 20.0g | C-2: 16.0g | 31. 3g | 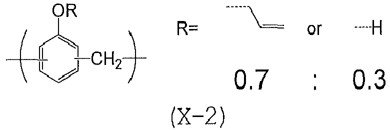 |
| 3 | A-1: 20.0g | C-3: 13.5g | 31.3g | 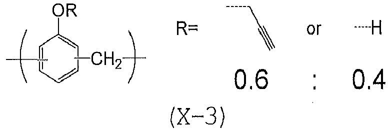 |
| 4 | A-1: 20.0g | C-3: 17.9g | 31.3g | 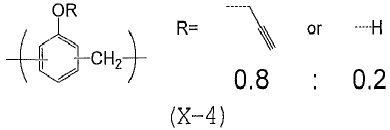 |
| 5 | A-2: 20.0g | C-1: 8.8g | 16.9g | 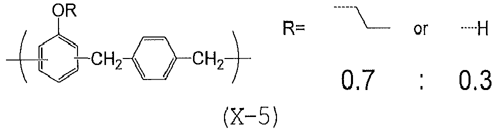 |
| 6 | A-2: 20.0g | C-2: 8.6g | 16.9g | 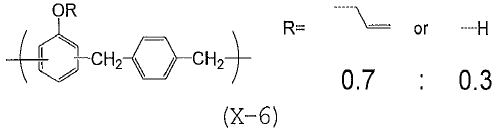 |
| 7 | A-2: 20.0g | C-3: 8.5g | 16.9g | 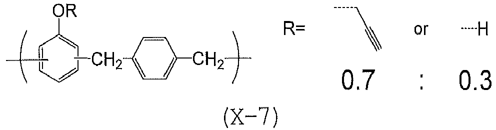 |
| 8 | A-3: 20.0g | C-1: 14.3g | 27.6g | 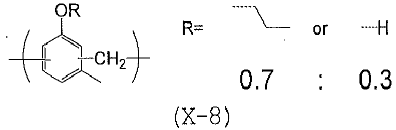 |

**[Table 2]**

| Synthesis Example | Resin | Modification agent | Potassium carbonate | Product |
|---|---|---|---|---|
| 9 | A-3: 20.0g | C-2: 14.1g | 27.6g | 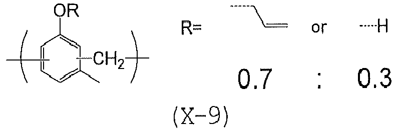 |
| 10 | A-3: 20.0g | C-3: 11.9g | 27.6g | 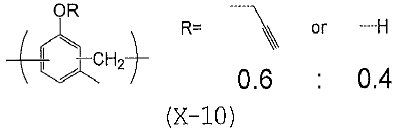 |
| 11 | A-3: 20.0g | C-3: 15.8g | 27.6g | 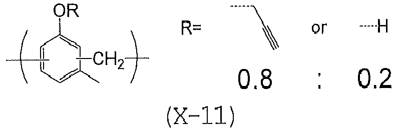 |
| 12 | A-4: 20.0g | C-1: 8.2g | 15.8g | 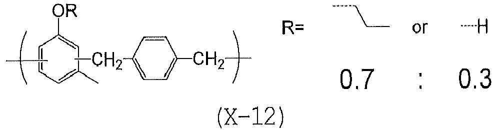 |
| 13 | A-4: 20.0g | C-2: 8.1g | 15.8g | 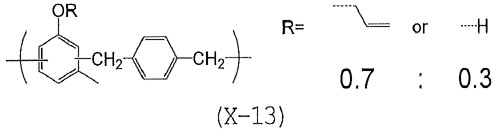 |
| 14 | A-4: 20.0g | C-3: 7.9g | 15.8g | 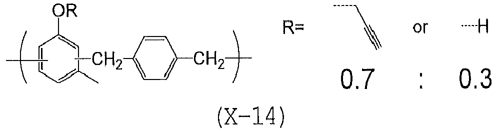 |
| 15 | A-5: 20.0g | C-3: 10.7g | 21.2g | 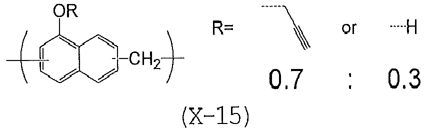 |
| 16 | A-6: 20.0g | C-3: 19.4g | 32.1g | 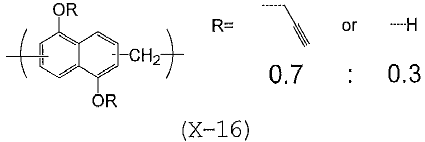 |

**[Table 3]**

| Synthesis Example | Resin | Modification agent | Potassium carbonate | Product |
|---|---|---|---|---|
| 17 | A-3: 20.0g | - | - | 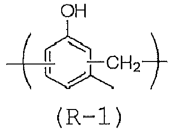 |
| 18 | A-3: 20.0g | C-3: 23.8g | 34.5g | 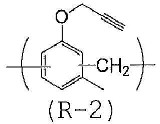 |
| 19 | A-3: 20.0g | C-3: 18.8g | 27.6g | 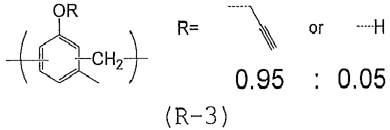 |
| 20 | A-3: 20.0g | C-3: 8.9g | 27.6g | 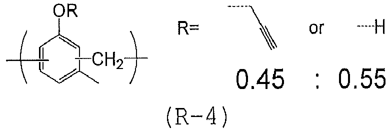 |

**[Table 4]**

| Resin | Mw | Mw/Mn |
|---|---|---|
| (X-1) | 8200 | 2.93 |
| (X-2) | 8100 | 2.88 |
| (X-3) | 7800 | 2.84 |
| (X-4) | 8400 | 2.88 |
| (X-5) | 7400 | 3.35 |
| (X-6) | 7200 | 3.41 |
| (X-7) | 7100 | 3.35 |
| (X-8) | 8900 | 3.61 |
| (X-9) | 8800 | 3.51 |
| (X-10) | 8500 | 3.46 |
| (X-11) | 9200 | 3.53 |
| (X-12) | 7800 | 3.31 |
| (X-13) | 7500 | 3.37 |
| (X-14) | 7700 | 3.35 |
| (X-15) | 4300 | 2.26 |
| (X-16) | 5100 | 2.68 |
| (R-1) | 7000 | 3.50 |
| (R-2) | 9400 | 3.59 |
| (R-3) | 9300 | 3.52 |
| (R-4) | 7900 | 3.46 |

### Preparation of Resist Underlayer Film Materials (UL-1 to -18, Comparative UL-1 to -4)

In proportions shown in the following tables, each of Resins (X-1) to (X-16) and (R-1) to (R-4) was dissolved in an organic solvent containing 0.1 mass% FC-4430 (a product of 3M Corporation which was purified by the applicant) optionally with Crosslinking agent (C1). The resulting solution was filtered through a 0.1-µm filter made of a fluorinated resin. In this manner, resist underlayer film materials (UL-1 to -18, Comparative UL-1 to -4) were prepared.

**[Table 5]**

| Resist underlayer film material | Resin (parts by mass) | Crosslinking agent (parts by mass) | Organic solvent (parts by mass) |
|---|---|---|---|
| UL-1 | X-1 (100) | - | PGMEA (300) |
| UL-2 | X-2 (100) | - | PGMEA (300) |
| UL-3 | X-3 (100) | - | PGMEA (300) |
| UL-4 | X-4 (100) | - | PGMEA (300) |
| UL-5 | X-5 (100) | - | PGMEA (300) |
| UL-6 | X-6 (20) | - | PGMEA (300) |
| UL-7 | X-7 (100) | - | PGMEA (300) |
| UL-8 | X-8 (100) | - | PGMEA (300) |
| UL-9 | X-9 (100) | - | PGMEA (300) |
| UL-10 | X-10 (100) | - | PGMEA (300) |
| UL-11 | X-11 (100) | - | PGMEA (300) |
| UL-12 | X-12 (100) | - | PGMEA (300) |
| UL-13 | X-13 (100) | - | PGMEA (300) |
| UL-14 | X-14 (100) | - | PGMEA (300) |
| UL-15 | X-15 (100) | - | PGMEA (300) |
| UL-16 | X-16 (100) | - | PGMEA (300) |

| | | | |
|---|---|---|---|
| PGMEA: propylene glycol monomethyl ether acetate | | | |

**[Table 6]**

| Resist underlayer film material | Resin (parts by mass) | Crosslinking agent (parts by mass) | Organic solvent (parts by mass) |
|---|---|---|---|
| UL-17 | X-10 (100) | C1 (30) | PGMEA (300) |
| UL-18 | X-11 (100) | C1 (30) | PGMEA (300) |
| Comparative UL-1 | R-1 (100) | - | PGMEA (300) |
| Comparative UL-2 | R-2 (100) | - | PGMEA (300) |
| Comparative UL-3 | R-3 (100) | - | PGMEA (300) |
| Comparative UL-4 | R-4 (100) | - | PGMEA (300) |

| | | | |
|---|---|---|---|
| PGMEA: propylene glycol monomethyl ether acetate | | | |

Crosslinking agent (C1) in Table 6 is specifically as follows.

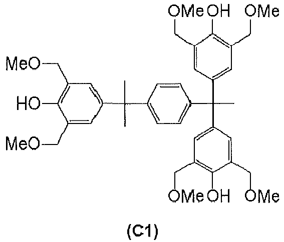

### Solvent Resistance Measurement (Examples 1-1 to 1-18, Comparative Examples 1-1 to 1-4)

Each of the resist underlayer film materials (UL-1 to -18, Comparative UL-1 to -4) prepared above was applied onto a silicon substrate, and baked for 60 seconds at a temperature shown in the following table. After the film thickness was measured, a PGMEA solvent was dispensed on the film. The resultant was left standing for 30 seconds, spin dried, and baked at 100°C for 60 seconds to evaporate the PGMEA solvent. The film thickness was measured again to evaluate the solvent resistance based on film thickness difference between before and after the PGMEA treatment. The following table shows the results.

**[Table 7]**

| | Resist underlayer film material | Film thickness after film formation: a (A) | Film thickness after solvent treatment: b(Å) | b/a×100(%) | Baking temperature |
|---|---|---|---|---|---|
| Example 1-1 | UL-1 | 14992 | 14995 | 100 | 250°C |
| Example 1-2 | UL-2 | 14971 | 14974 | 100 | 250°C |
| Example 1-3 | UL-3 | 14909 | 14912 | 100 | 250°C |
| Example 1-4 | UL-4 | 15034 | 15037 | 100 | 250°C |
| Example 1-5 | UL-5 | 14826 | 14829 | 100 | 250°C |
| Example 1-6 | UL-6 | 14784 | 14787 | 100 | 250°C |
| Example 1-7 | UL-7 | 14763 | 14767 | 100 | 250°C |
| Example 1-8 | UL-8 | 15138 | 15141 | 100 | 250°C |
| Example 1-9 | UL-9 | 15117 | 15120 | 100 | 250°C |
| Example 1-10 | UL-10 | 15055 | 15057 | 100 | 250°C |
| Example 1-11 | UL-11 | 15200 | 15203 | 100 | 250°C |
| Example 1-12 | UL-12 | 14909 | 14912 | 100 | 250°C |
| Example 1-13 | UL-13 | 14847 | 14850 | 100 | 250°C |
| Example 1-14 | UL-14 | 14888 | 14891 | 100 | 250°C |
| Example 1-15 | UL-15 | 14180 | 14185 | 100 | 250°C |
| Example 1-16 | UL-16 | 14347 | 14351 | 100 | 250°C |
| Example 1-17 | UL-17 | 15065 | 15067 | 100 | 250°C |
| Example 1-18 | UL-18 | 15210 | 15213 | 100 | 250°C |
| Comparative Example 1-1 | Comparative UL-1 | 14742 | 14746 | 100 | 250°C |
| Comparative Example 1-2 | Comparative UL-2 | 15242 | 15244 | 100 | 250°C |
| Comparative Example 1-3 | Comparative UL-3 | 15221 | 15224 | 100 | 250°C |
| Comparative Example 1-4 | Comparative UL-4 | 14930 | 14933 | 100 | 250°C |

It can be seen that all the resist underlayer film materials obtained by the inventive patterning process had favorable film formability, caused little film reductions by the solvent treatment, and resulted in films with favorable solvent resistance.

### Filling Property Evaluation (Examples 2-1 to 2-18, Comparative Examples 2-1 to 2-4)

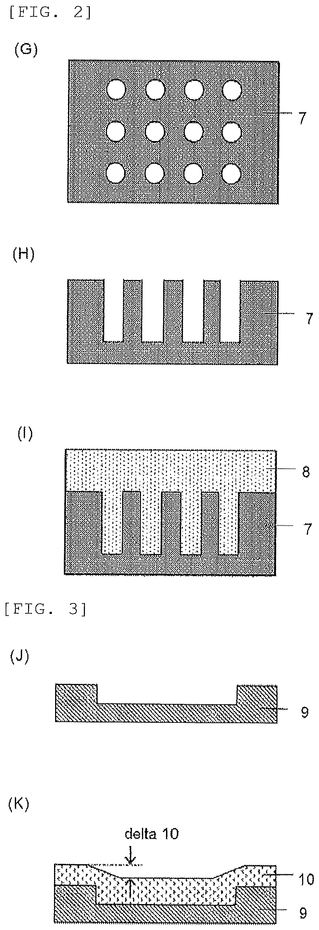

The above resist underlayer film materials were each applied onto a SiO₂ wafer substrate 7 having a dense hole pattern (hole diameter: 0.16 µm, hole depth: 2.0 µm, distance between the centers of two adjacent holes: 0.40 µm) and baked for 60 seconds at a temperature shown in the following table. In this manner, resist underlayer films 8 were formed. The substrates used were each a SiO₂ wafer substrate having a dense hole pattern as shown in FIG. 2 (G) (top view) and FIG. 2 (H) (sectional view). The sectional shapes of the resulting wafer substrates were observed with a scanning electron microscope (SEM) to check whether or not the holes were filled with the resist underlayer film without voids (space) and without peeling at the interface between the pattern sidewall and the resist underlayer film material. The following table shows the results. If a resist underlayer film material having poor filling property is used in this evaluation, voids occur inside the holes. Moreover, if a resist underlayer film material having poor adhesiveness is used in this evaluation, peeling occurs at the interface between the pattern sidewall and the resist underlayer film material. When a resist underlayer film material having favorable filling property and adhesiveness is used in this evaluation, the holes are filled with the resist underlayer film without voids or peeling as shown in FIG. 2 (I).

**[Table 8]**

| | Resist underlayer film material | Baking temperature | Presence/ absence of voids | Presence/ absence of peeling |
|---|---|---|---|---|
| Example 2-1 | UL-1 | 250°C | absent | absent |
| Example 2-2 | UL-2 | 250°C | absent | absent |
| Example 2-3 | UL-3 | 250°C | absent | absent |
| Example 2-4 | UL-4 | 250°C | absent | absent |
| Example 2-5 | UL-5 | 250°C | absent | absent |
| Example 2-6 | UL-6 | 250°C | absent | absent |
| Example 2-7 | UL-7 | 250°C | absent | absent |
| Example 2-8 | UL-8 | 250°C | absent | absent |
| Example 2-9 | UL-9 | 250°C | absent | absent |
| Example 2-10 | UL-10 | 250°C | absent | absent |
| Example 2-11 | UL-11 | 250°C | absent | absent |
| Example 2-12 | UL-12 | 250°C | absent | absent |
| Example 2-13 | UL-13 | 250°C | absent | absent |
| Example 2-14 | UL-14 | 250°C | absent | absent |
| Example 2-15 | UL-15 | 250°C | absent | absent |
| Example 2-16 | UL-16 | 250°C | absent | absent |
| Example 2-17 | UL-17 | 250°C | absent | absent |
| Example 2-18 | UL-18 | 250°C | absent | absent |
| Comparative Example 2-1 | Comparative UL-1 | 250°C | present | absent |
| Comparative Example 2-2 | Comparative UL-2 | 250°C | absent | present |
| Comparative Example 2-3 | Comparative UL-3 | 250°C | absent | present |
| Comparative Example 2-4 | Comparative UL-4 | 250°C | present | absent |

The above results show that the resist underlayer film materials (UL-1 to -18) of Examples are capable of filling the hole pattern without voids and peeling, and are excellent in filling property and adhesiveness. In contrast, the resist underlayer film materials (Comparative UL-1 and Comparative UL-4) of Comparative Examples presumably have insufficient flowability due to large amounts of hydroxyl groups in the resins, so that the voids occurred as filling defect. Moreover, although the resist underlayer film materials (Comparative UL-2 and Comparative UL-3) of Comparative Examples did not cause voids, the modification percentage of hydroxyl groups was presumably so high that the hydroxyl group amount in the resins was not enough, and the peeling occurred due to insufficient adhesiveness.

### Planarizing Property Evaluation (Examples 3-1 to 3-18, Comparative Example 3-1)

The above resist underlayer film materials were each diluted with PGMEA such that the resulting film thickness would be 0.2 µm, and then applied onto a SiO₂ wafer substrate 9 having a giant isolated trench pattern (FIG. 3 (J), trench width: 10 µm, trench depth: 0.1 pm) and baked under conditions shown in the following table. In this manner, resist underlayer films 10 were formed. Then, the film thickness difference (delta 10 in FIG. 3 (K)) between the trench portion and the non-trench portion of each resist underlayer film was observed with a scanning electron microscope (SEM). The following table shows the results. In this evaluation, it can be said that the smaller the film thickness difference, the better the planarizing property.

**[Table 9]**

| | Resist underlayer film material | Baking conditions | Film thickness difference (nm) |
|---|---|---|---|
| Example 3-1 | UL-1 | 250°C × 60 seconds | 35 |
| Example 3-2 | UL-2 | 250°C × 60 seconds | 35 |
| Example 3-3 | UL-3 | 250°C × 60 seconds | 30 |
| Example 3-4 | UL-4 | 250°C × 60 seconds | 25 |
| Example 3-5 | UL-5 | 250°C × 60 seconds | 40 |
| Example 3-6 | UL-6 | 250°C × 60 seconds | 40 |
| Example 3-7 | UL-7 | 250°C × 60 seconds | 35 |
| Example 3-8 | UL-8 | 250°C × 60 seconds | 45 |
| Example 3-9 | UL-9 | 250°C × 60 seconds | 45 |
| Example 3-10 | UL-10 | 250°C × 60 seconds | 40 |
| Example 3-11 | UL-11 | 250°C × 60 seconds | 35 |
| Example 3-12 | UL-12 | 250°C × 60 seconds | 50 |
| Example 3-13 | UL-13 | 250°C × 60 seconds | 50 |
| Example 3-14 | UL-14 | 250°C × 60 seconds | 45 |
| Example 3-15 | UL-15 | 250°C × 60 seconds | 55 |
| Example 3-16 | UL-16 | 250°C × 60 seconds | 50 |
| Example 3-17 | UL-17 | 250°C × 60 seconds | 40 |
| Example 3-18 | UL-18 | 250°C × 60 seconds | 35 |
| Comparative Example 3-1 | Comparative UL-1 | 250°C × 60 seconds | 85 |

The above results show that the resist underlayer film materials (UL-1 to -18) of Examples are excellent in planarizing property because the film thickness difference in each resist underlayer film between the trench portion and the non-trench portion was small in comparison with the resist underlayer film material (Comparative UL-1) of Comparative Example. The resist underlayer film material (Comparative UL-1) of Comparative Example with low modification percentage of hydroxyl groups had low thermal flowability, thereby presumably degrading the planarizing property. Meanwhile, even though the modification percentage of hydroxyl groups is preferably high in order to improve the planarizing property, if the modification percentage is too high, the resulting film might be peeled from the substrate to be processed as described above. This invention appropriately controls the modification percentage of hydroxyl groups, thereby successfully achieving both favorable planarizing property and filling property.

### In-Plane Film Thickness Uniformity Evaluation (Examples 4-1 to 4-18, Comparative Examples 4-1 to 4-4)

The above resist underlayer film materials were each applied onto a silicon substrate in such manners as to achieve three levels of: Evaluation film thickness 1 (1000 nm), Evaluation film thickness 2 (1500 nm) and Evaluation film thickness 3 (3000 nm). After baking at 250°C for 60 seconds, the film thickness was measured across the entire surface of each wafer. The maximum value, minimum value, and average value of the film thickness were obtained to evaluate the in-plane film thickness uniformity. If a value obtained by dividing the difference of (maximum value-minimum value) of film thickness by the average film thickness thereof was less than 2%, the material was evaluated as "A" (quite favorable). If the value was 2% or more and less than 5%, the material was evaluated as "B" (favorable). If the value was 5% or more, the material was evaluated as "C" (poor). The following table shows the results.

**[Table 10]**

| | Resist underlayer film material | Evaluation film thickness 1 (1000 nm) | Evaluation film thickness 2 (1500 nm) | Evaluation film thickness 3 (3000 nm) |
|---|---|---|---|---|
| | | Result | Result | Result |
| Example 4-1 | UL-1 | A | A | A |
| Example 4-2 | UL-2 | A | A | A |
| Example 4-3 | UL-3 | A | A | A |
| Example 4-4 | UL-4 | A | A | A |
| Example 4-5 | UL-5 | A | A | A |
| Example 4-6 | UL-6 | A | A | A |
| Example 4-7 | UL-7 | A | A | A |
| Example 4-8 | UL-8 | A | A | A |
| Example 4-9 | UL-9 | A | A | A |
| Example 4-10 | UL-10 | A | A | A |
| Example 4-11 | UL-11 | A | A | A |
| Example 4-12 | UL-12 | A | A | A |
| Example 4-13 | UL-13 | A | A | A |
| Example 4-14 | UL-14 | A | A | A |
| Example 4-15 | UL-15 | A | A | B |
| Example 4-16 | UL-16 | A | A | B |
| Example 4-17 | UL-17 | A | A | A |
| Example 4-18 | UL-18 | A | A | A |
| Comparative Example 4-1 | Comparative UL-1 | A | B | B |
| Comparative Example 4-2 | Comparative UL-2 | A | A | B |
| Comparative Example 4-3 | Comparative UL-3 | A | A | B |
| Comparative Example 4-4 | Comparative UL-4 | A | A | B |

The above results show that the resist underlayer film materials (UL-1 to -18) of Examples are excellent in in-plane film thickness uniformity. The resist underlayer film materials (Comparative UL-1 and Comparative UL-4) of Comparative Examples with low modification percentage of hydroxyl groups showed such a that the thicker the evaluation film thickness, the poorer the in-plane film thickness uniformity. This is possibly due to the low flowability. In contrast, the resist underlayer film materials (UL-1 to -14, -17, -18) of Examples, in which the modification percentage is appropriately controlled, stably exhibited excellent in-plane film thickness uniformity in all the evaluation film thicknesses.

From the above, the inventive resist underlayer film materials, patterning process, and method for forming a resist underlayer film are suitably utilizable in multilayer resist processes for fine patterning in manufacturing semiconductor devices. Particularly, the present invention is also applicable to multilayer resist processes using a substrate to be processed having a portion with a large aspect ratio that makes especially gap-filling difficult, as typified by 3D-NAND memories being manufactured in highly laminated forms, and is industrially quite useful.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. A resist underlayer film material used in a multilayer resist method, comprising:
(A) a resin having a structural unit shown by the following general formula (1); and
(B) an organic solvent,
wherein the resin is contained in an amount of 20 mass% or more, 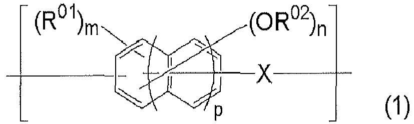
wherein R⁰¹ represents a saturated or unsaturated monovalent organic group having 1 to 30 carbon atoms optionally having a substituent; R⁰² represents a hydrogen atom or a saturated or unsaturated monovalent organic group having 1 to 30 carbon atoms optionally having a substituent, and the structures constituting R⁰² satisfy relations of a+b=1, 0.1≤a≤0.5, and 0.5≤b≤0.9, where "a" represents a proportion of the hydrogen atom, and "b" represents a proportion of the monovalent organic group; X represents a divalent organic group having 1 to 30 carbon atoms; "m" represents an integer of 0 to 5, "n" represents an integer of 1 to 6, and m+n is an integer of 1 or more and 6 or less; and "p" represents 0 or 1.

2. The resist underlayer film material according to claim 1, wherein in the general formula (1), the R⁰² is any of a hydrogen atom, an alkyl group having 1 to 10 carbon atoms, and structures shown in the following general formula (2), 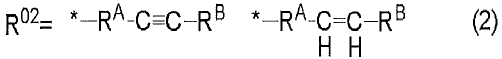 wherein * represents an attachment point to an oxygen atom, R^{A} represents a divalent organic group having 1 to 10 carbon atoms optionally having a substituent, and R^{B} represents a hydrogen atom or a monovalent organic group having 1 to 10 carbon atoms optionally having a substituent.

3. The resist underlayer film material according to claim 1 or 2, wherein in the general formula (1), "a" and "b" satisfy relations of a+b=1, 0.15≤a≤0.4, and 0.6≤b≤0.85.

4. The resist underlayer film material according to any one of claims 1 to 3, wherein in the general formula (1), "p" is 0.

5. The resist underlayer film material according to any one of claims 1 to 4, wherein in the general formula (1), "n" is 1.

6. The resist underlayer film material according to any one of claims 1 to 5, wherein the resin (A) has a weight-average molecular weight of 3,000 to 10,000.

7. The resist underlayer film material according to any one of claims 1 to 6, wherein the resist underlayer film material comprises (C) a crosslinking agent.

8. The resist underlayer film material according to any one of claims 1 to 7, wherein the resist underlayer film material further comprises one or more of (D) an acid generator, (E) a surfactant, (F) a plasticizer, and (G) a pigment.

9. A patterning process for forming a pattern in a substrate to be processed, comprising steps of:
(I-1) applying the resist underlayer film material according to any one of claims 1 to 8 onto the substrate to be processed, followed by heating to form a resist underlayer film;
(1-2) forming a resist upper layer film on the resist underlayer film by using a photoresist material;
(1-3) subjecting the resist upper layer film to pattern exposure and then development with a developer to form a pattern in the resist upper layer film;
(1-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

10. A patterning process for forming a pattern in a substrate to be processed, comprising steps of:
(II-1) applying the resist underlayer film material according to any one of claims 1 to 8 onto the substrate to be processed, followed by heating to form a resist underlayer film;
(II-2) forming a silicon-containing resist middle layer film on the resist underlayer film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the resist underlayer film by dry etching while using the silicon-containing resist middle layer film having the transferred pattern as a mask; and
(II-7) processing the substrate to be processed while using the resist underlayer film having the formed pattern as a mask to form the pattern in the substrate to be processed.

11. A patterning process for forming a pattern in a substrate to be processed, comprising steps of:
(III-1) applying the resist underlayer film material according to any one of claims 1 to 8 onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

12. The patterning process according to any one of claims 9 to 11, wherein the substrate to be processed has a structure or step with an aspect ratio of 10 or more.

13. A method for forming a resist underlayer film that serves as an organic filling film employed in a semiconductor device manufacturing process, the method comprising:
spin-coating a substrate to be processed with the resist underlayer film material according to any one of claims 1 to 8; and
heating the substrate to be processed coated with the resist underlayer film material at a temperature of 100°C or higher and 600°C or lower for 10 to 600 seconds to form a cured film, preferably
wherein the substrate to be processed has a structure or step with an aspect ratio of 10 or more.

14. A method for forming a resist underlayer film that serves as an organic filling film employed in a semiconductor device manufacturing process, the method comprising:
spin-coating a substrate to be processed with the resist underlayer film material according to any one of claims 1 to 8; and
heating the substrate to be processed coated with the resist underlayer film material under an atmosphere with an oxygen concentration of 1% or more and 21% or less to form a cured film, preferably
wherein the substrate to be processed has a structure or step with an aspect ratio of 10 or more.

15. A method for forming a resist underlayer film that serves as an organic filling film employed in a semiconductor device manufacturing process, the method comprising:
spin-coating a substrate to be processed with the resist underlayer film material according to any one of claims 1 to 8; and
heating the substrate to be processed coated with the resist underlayer film material under an atmosphere with an oxygen concentration of less than 1% to form a cured film, preferably
wherein the substrate to be processed has a structure or step with an aspect ratio of 10 or more.
